(19) **Europäisches Patentamt / European Patent Office / Office européen des brevets**

(11) **EP 3 261 343 A1**

(12) **EUROPEAN PATENT APPLICATION**
published in accordance with Art. 153(4) EPC

(43) Date of publication:
**27.12.2017 Bulletin 2017/52**

(21) Application number: **16751905.7**

(22) Date of filing: **28.01.2016**

(51) Int Cl.:
**H04N 17/00** (2006.01)

(86) International application number:
**PCT/CN2016/072496**

(87) International publication number:
**WO 2016/131374 (25.08.2016 Gazette 2016/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **17.02.2015 CN 201510086484**

(71) Applicant: **Liu, Jianqiu**
**Beijing 100000 (CN)**

(72) Inventor: **Liu, Jianqiu**
**Beijing 100000 (CN)**

(74) Representative: **Stork Bamberger Patentanwälte PartmbB**
**Meiendorfer Strasse 89**
**22145 Hamburg (DE)**

(54) **INTERFERENCE SIGNAL RECORDING DEVICE, AND SYSTEM AND METHOD FOR LOCATING FAULT POINT OF CABLE TELEVISION NETWORK**

(57) The invention provides an interference signal recording device, a system and method for locating impairment sources in a cable network by means of the interference signal recording device: one interference signal recording device is installed on the headend of the cable network, another signal recording device is installed in a cable branch of the cable network via a signal coupler; both interference signal recording devices comprise samplers; each of the interference signal recording device starts to sample the interference signal at the moment when receiving a predetermined sampling timing signal from downstream signals; a computer is used for obtaining digital sample sequences of the interference signals obtained by sampling of the two interference signal recording devices via the Internet and for calculating a cross-correlation function of the two digital sample sequences; it can be determined whether an impairment source exists in a signal delivering path passing through the location of signal coupler in the downstream, in accordance with presence or absence of a cross-correlation peak caused by the impairment source in the cross-correlation function graph as a calculation result.

FIG. 1

**Description**

FIELD OF THE INVENTION

The disclosure relates a field of communication technology, in particular an interference signal recording device as well as system and method for locating impairment sources in a cable network.

BACKGROUND OF THE INVENTION

Various impairments in a Hybrid Fiber Coax (HFC) cable network generally occur in a coaxial coaxial cable network therein. Types of impairments often occurring in the coaxial coaxial cable network include cable deformation, cable shield damage, corrosion in contact surface of connectors, poor contact between connectors and an open-circuit at a terminal output port, etc. In any case, interference signals are produced in impairment sources of various impairments, impacting on the operation of cable networks, especially impacting on broadband access services.

The performance of the cable network is improved by the technology for locating impairment sources in a cable network through three aspects: firstly, finding the impairments early and quickly and restoring them before impacting on the services; secondly, restoring the impairments early and quickly and shortening duration time of each of the impairments; thirdly, accompanied with the shortened duration time of each source of impairments, number of impairment sources existing in the network at the same time is decreased and then the interference signal amplitude is reduced.

Three types of interference signals can be produced in the impairment sources due to the different types of impairments. First types of signals are external interference signals, which are the signals of the electromagnetic signals in the environment where the coaxial cable network is entering the cable networks via the impairment sources. Second types of signals are common path distortion signals which are produced by common path distortion. Nonlinear voltage-current characteristic may be caused on the contact interface corroded in connectors. Nonlinear Signals are produced when the downstream signals in the cable network pass through said surface. The common path distortion signals mainly include second-order distortion products and third-order distortion products. Third types of the signals are reflection signals which are signals produced at impedance mismatch points and reflected in a direction toward signal source.

A technical solution for locating impairment sources commonly applied at present is a method using controlled switches. A frequency spectrum monitoring apparatus is installed upstream of the network to monitor frequency spectrum of the upstream signals. Controlled switches which can attenuate amplitude of the upstream signals are installed in a plurality of cable branches downstream of the network. While switching is occurring in a certain controlled switch, if the amplitude of the interference signal is changing along with the pattern of the switching , it can be determined that an impairment source exists downstream of the controlled switch. The method using controlled switches can locate impairment sources where any type of interference signals is produced. The United States Patent "method and apparatus for locating network impairments" (application number US 20080320541) is an example of locating impairment sources with the method using controlled switch. The first disadvantage of the method using controlled switches is that when the location where the controlled switches is installed is closer to upstream of the coaxial cable network, the scale of the coaxial cable network downstream of the controlled switch is too large, which is not good for on-site searching of the impairment sources; and that when the location where the controlled switches is installed is closer to downstream of the coaxial cable network, the length of a line upstream of the controlled switches beyond locating range is too long.

A method aimed at locating impairment sources where external interference signals are produced is introduced by the United States patent "methods and apparatus for detecting and locating leakage of digital signal"(application number US 2110043640). The technical solution is used to detect leakage sources in the coaxial cable network by means of a series of space radio locating methods. In the technical solution, during the process of detection of the leakage signal and measurement of time delay, a method for calculating a cross-correlation function of a received leaking signal and a generated reference signal is used. Because impairment sources where leaking signals are produced are also the impairment sources where external interference signal are produced, the locating result by the method, of course, is also the locating result of impairment sources where the external interference signals are produced. In the technical solution, signal detection performed on the road around the coaxial cable network needs a heavy manual workload. Another disadvantage of the technical solution is that impairment sources in a building cannot be located.

A method aimed at locating impairment sources where common path distortion signals are produced is introduced by the United States patent "method and apparatus for pinpointing common path distortion" (application number US 20060248564). In the method, generating a common path distortion signal produced by common path distortion upstream of the network by utilizing a downstream signal, as a reference signal; receiving a common path distortion signal at a reference signal generating point in an upstream path; calculating a cross-correlation function of these two signals to get transmission time delay, and then calculating to get the distance from the reference signal generating point to the impairment source. Because the coaxial cable network is a multiple-branch network, more than one point corresponding to the same distance exist, it is impossible to identify the cable branch in which the impairment source exists by this method.

A method aimed at locating impairment sources where reflections are produced is introduced by the United States patent "method and apparatus for determining micro-reflections in a network" (application number US 20080140823). In the method, transmitting a test signal in the upstream direction from a subscriber apparatus, receiving the test signal by an upstream detecting device, calculating the amplitude ratio of the reflections and direct signals, and the time difference between the reflections and direct signals, thereby it can be determined which upstream signal transmission path of the subscriber apparatus the impairment source exists in. The main disadvantage of this method is that it is impossible to identify the exact location of the impairment source in the path.

A cable modem with a power measurement circuit is introduced by the United States patent "cable modems and systems and methods for identification of a noise signal source on a network" (application number US 6772437 B1). The cable modem which is installed at a user port in the cable network can measure the power of an interference signal delivered to the port along the cable line. A value of the power is delivered to a noise source identification system, the noise source identification system thereby determines whether impairment sources exist in the cable line around the cable modem installation location. The damage degree of the interference signal to the cable network is dependent on the amplitude of the interference signal in an upstream signal receiver. Generally, transmission losses from different locations of the coaxial cable network to the upstream signal receiver and to the closest cable modem installation location are in big difference. Thus, in terms of impairment sources at different locations, even if the powers of the interference signals at each of impairment sources measured by the respective closest cable modems are the same, the amplitudes of the interference signals arriving at the upstream signal receiver from the impairment sources at different locations may be quite different. This severely reduces the reliability of the locating results.

## SUMMARY OF THE INVENTION

The disclosure provides an interference signal recording device as well as a system and a method for locating impairment sources in cable network.

An interference signal recording device provided in the present invention comprises:

    a radio frequency port for connecting to a cable line of a cable network;
    a signal receiver connected to the radio frequency port;
    a sampler connected to the radio frequency port;
    a microprocessor connected to the signal receiver and to the sampler, wherein the microprocessor is designed to associate a digital sample sequence of an interference signal obtained by sampling of the sampler with a moment when a sampling timing signal reaches the present device and is received by the signal receiver.

Accordingly, the interference signal recording device can associate a digital sample sequence of an interference signal obtained by sampling with an arriving moment of a sampling timing signal. Thus, when each of two interference signal recording devices respectively installed upstream and downstream of the cable network associates the digital sample sequences of the interference signal obtained by sampling individually with the arriving moment of the common sampling timing signal transmitted from a common signal source, time association between the two digital sample sequences obtained by sampling of the two recording devices is achieved, so that during calculation for a cross-correlation function of these two digital sample sequences, presence or absence of an impairment source can be determined according to presence or absence of a cross-correlation peak caused by the impairment source in a cross-correlation function graph.

Furthermore, another interference signal recording device provided in the present invention comprises:

    a radio frequency port for connecting to a cable line of a cable network;
    a signal transmitter connected to the radio frequency port;
    a sampler connected to the radio frequency port;
    a microprocessor connected to the signal transmitter and to the sampler, wherein the microprocessor is designed to associate a digital sample sequence of an interference signal obtained by sampling of the sampler with a transmitting moment when a sampling timing signal is transmitted by the signal transmitter.

Furthermore, a system for locating impairment sources in cable network provided in the present invention comprises:

    a common path distortion reference signal recorder connected to the cable network, which generates and samples a common path distortion reference signal, and associates a digital sample sequence of the reference signal obtained by sampling with a moment when a sampling timing signal delivered via the cable line reaches said reference signal recorder, or with a transmitting moment when a sampling timing signal is transmitted from the reference signal recorder;

an interference signal recording device installed downstream of the cable network, which samples an interference signal in the cable network, and associates a digital sample sequence of the interference signal obtained by sampling with a moment when a sampling timing signal delivered via the cable network line reaches said device, or with a transmitting moment when a sampling timing signal is transmitted from the said device;

an impairment source locating and calculating device connected with the interference signal recording device installed in the downstream and the common path distortion reference signal recorder by means of communication media, which calculates a cross-correlation function of the digital sample sequence of the common path distortion reference signal and the digital sample sequence of the interference signal.

Accordingly, a common path distortion reference signal recorder and an interference signal recording device installed downstream of the cable network, each of them associates a digital sample sequence of the reference signal and a digital sample sequence of the interference signal respectively with an arriving moment of a common sampling timing signal transmitted by a common signal source, or associates one sequence with the arriving moment of the sampling timing signal on the one hand and associates the other sequence with an transmitting moment of the sampling timing signal on the other hand; an impairment source locating and calculating device calculates a cross-correlation function of the two sequences. Thus, presence or absence of an impairment source causing a common path distortion signal in the corresponding cable line can be determined according to presence or absence of a cross-correlation peak caused by the impairment source in a cross-correlation function graph.

Alternatively, the system further comprises:

an interference signal recording device installed upstream of the cable network, which samples an interference signal in the cable network, and associates a digital sample sequence of the interference signal obtained by sampling with a moment when a sampling timing signal delivered via the cable network line reaches said device, or with a moment when a sampling timing signal is transmitted from the device; the interference signal recording device is connected with the impairment source locating and calculating device by means of communication media, the locating and calculating device calculates a cross-correlation function of a digital sample sequence of the interference signal and the digital sample sequence of the common path distortion reference signal.

Accordingly, an interference signal recording device is installed upstream so that a cable length between the impairment source generating the common path distortion signal and a locating base point can be determined. Furthermore, a system for locating impairment sources in cable network provided in the present invention comprises:

an interference signal recording device installed upstream of the cable network, which samples an interference signal in the cable network, and associates a digital sample sequence of the interference signal obtained by sampling with a moment when a sampling timing signal delivered via the cable network line reaches said device, or with a moment when a sampling timing signal is transmitted from the device;

an interference signal recording device installed downstream of the cable network, which samples an interference signal in the cable network, and associates a digital sample sequence of the interference signal obtained by sampling with a moment when a sampling timing signal delivered via the cable network line reaches said device, or with a moment when a sampling timing signal is transmitted from the device;

an impairment source locating and calculating device connected with the interference signal recording device installed in the downstream and the interference signal recording device installed in the upstream by means of communication media, the impairment source locating and calculating device calculates a cross-correlation function of the digital sample sequence obtained by sampling of the interference signal recording device installed in the upstream and the digital sample sequence obtained by sampling of interference signal recording device installed in the downstream.

Accordingly, two interference signal recording devices respectively installed upstream and downstream of the cable network, each of them associates digital sample sequences of the interference signals obtained by sampling respectively with an arriving moment of a common sampling timing signal transmitted by a common signal source, or associates one sequence with the arriving moment of the sampling timing signal on the one hand and associates the other sequence with an transmitting moment of the sampling timing signal on the other hand; an impairment source locating and calculating device calculates a cross-correlation function of the two sequences. Thus, presence or absence of an impairment source in the corresponding cable line can be determined according to presence or absence of a cross-correlation peak caused by the impairment source in a cross-correlation function graph.

Alternatively, the system further comprises:

a signal coupler connected between the interference signal recording device installed in the downstream and the cable line of the cable network, which couples interference signals each produced in the upstream and the downstream lines of the signal coupler to the interference signal recording device installed in the downstream.

Accordingly, a signal coupler can provide the coupled interference signals which are produced downstream of the coupler, to the interference signal recording device. Thus, an impairment source downstream of the coupler can be located in the system. Furthermore, by the signal coupler, any signal which is produced downstream of the signal coupler is coupled and provided to the connected interference signal recording device, also is delivered upstream so as to be received by the upstream interference signal recording device. Thus, an upstream service signal or an interference signal produced in the downstream line of the signal coupler can be used as a testing signal which can be used for measuring a time delay value in a cross-correlation function graph corresponding to the location of the signal coupler, so that the location of the signal coupler acts as a easily usable locating base point.

Furthermore, a method for locating impairment sources in cable network provided in the present invention comprises steps of:

A. transmitting a sampling timing signal to a cable network line;

B. selecting a detection point in the cable network, picking up a downstream signal in the detection point, generating a common path distortion reference signal by using the downstream signal, sampling the reference signal, and associating a digital sample sequence of the reference signal obtained with a moment when a sampling timing signal reaches the detection point or with a transmitting moment when it is transmitted at the detection point;

C. selecting a downstream detection point in the downstream of the cable network, picking up an interference signal in the downstream detection point, sampling the interference signal, and associating a digital sample sequence of the interference signal obtained with a moment when a sampling timing signal reaches the downstream detection point or with a transmitting moment when it is transmitted at the detection point;

D. calculating a cross-correlation function of the digital sample sequence as described in step B and the digital sample sequence as described in step C;

E. determining presence of an impairment source in a signal delivering path passing through the downstream detection point based on a condition that a cross-correlation peak caused by the impairment source exists in a cross-correlation function graph obtained by calculating the cross-correlation function.

Accordingly, a downstream signal is picked up at a detection point in the cable network so that a common path distortion reference signal of the downstream signal is generated and then sampled; an interference signal is picked up at a detection point in the cable network and is sampled; a digital sample sequence of the reference signal obtained by sampling and a digital sample sequence of an interference signal are associated respectively with an arriving moment of a sampling timing signal delivered in the line, or one sequence is associated with the arriving moment of the sampling timing signal and the other sequence is associated with the transmitting moment of the sampling timing signal; a cross-correlation function of the two sequences is calculated; it can be determined whether an impairment source exists in a signal delivering path passing through the downstream detection point, according to whether a cross-correlation peak caused by the impairment source exists in the cross-correlation function graph.

Alternatively, a step after the step B is further included:

B1. selecting an upstream detection point upstream of the cable network, picking up an interference signal in the upstream detection point, sampling the interference signal, and associating a digital sample sequence of the interference signal obtained with a moment when a sampling timing signal reaches the upstream detection point or with a transmitting moment when it is transmitted at the upstream detection point; and

a step after the step D is further included:

D1. calculating a cross-correlation function of the digital sample sequence as described in step B and the digital sample sequence as described in step B1;

and steps after the step E are further included:

F. selecting the cross-correlation peak only caused by the impairment source in the signal delivering path as described in step E in the cross-correlation function graph obtained by calculating the cross-correlation function as described in step D1;

G. determining the location of the impairment source in the line based on a time delay value of the cross-correlation peak caused by the impairment source as described in step F.

Furthermore, a method for locating impairment sources in cable network provided in the present invention comprises steps of:

A. transmitting a sampling timing signal to a cable network line;

B. selecting an upstream detection point upstream of the cable network, picking up an interference signal in the upstream detection point, sampling the interference signal, and associating a digital sample sequence of the interference signal obtained with a moment when a sampling timing signal reaches the upstream detection point or with a transmitting moment when it is transmitted at the upstream detection point; and

C. selecting a downstream detection point downstream of the cable network, picking up an interference signal in the downstream detection point, sampling the interference signal, and associating a digital sample sequence of the interference signal obtained with a moment when a sampling timing signal reaches the downstream detection point or with a transmitting moment when it is transmitted at the downstream detection point;

D. calculating a cross-correlation function of the digital sample sequence as described in step B and the digital sample sequence as described in step C;

E. determining presence of an impairment source in a signal delivering path passing through the downstream detection point based on a condition that a cross-correlation peak caused by the impairment source exists in a cross-correlation function graph obtained by calculating the cross-correlation function.

Accordingly, an interference signal is picked up at an upstream detection point and a downstream detection point in the cable network, and is sampled; the two digital sample sequences of the interference signal obtained by sampling are associated respectively with an arriving moment of a sampling timing signal delivered in the line, or one sequence is associated with the arriving moment of the sampling timing signal and the other sequence is associated with the transmitting moment of the sampling timing signal; a cross-correlation function of the two sequences is calculated; it can be determined whether an impairment source exists in a signal delivering path passing through the downstream detection point, according to whether a cross-correlation peak caused by the impairment source exists in the cross-correlation function graph.

Alternatively, a step after the step C is further included:

C1. selecting a second downstream detection point downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when the sampling timing signal reaches the second downstream detection point;

Step D further includes steps of:

D1: adjusting the digital sample sequence as described in step C and the digital sample sequence as described in step C1 so that the two sample sequences have the same amplitude value;

D2. calculating respectively cross-correlation functions of each of the digital sample sequences having the same amplitude value and the digital sample sequence as described in step B1;

Step E further includes a step of:

determining presence of impairment sources each in signal delivering paths passing through the downstream detection points as described respectively in step C and step C1, based on a condition that cross-correlation peaks caused by the impairment sources in each case exist in two cross-correlation function graphs obtained by calculating the cross-correlation functions as described in step D2; and

steps after the step E are further included:

F. from the two cross-correlation function graphs, respectively selecting a cross-correlation peak only caused by the impairment source in the signal delivering path passing through the downstream point as described in step C, and a cross-correlation peak only caused by the impairment source in a signal delivering path passing through the downstream point as described in step C1;

G. ranking degrees of damages to the network service resulted from impairment sources in the two different signal delivering paths, based on an order of amplitude value of the cross-correlation peaks selected from the two cross-correlation function graphs as described in step F.

Accordingly, the digital sample sequences of the interference signal obtained by sampling at the two downstream detection points which belong to different cable branches are adjusted so as to have the same amplitude value; the degrees of damages to the network service resulted from impairment sources in the different paths is ranked, based on an order of amplitude value of the cross-correlation peaks in the cross-correlation function graphs, which are obtained through the two digital sample sequences with the same amplitude value involving in cross-correlation calculation.

Alternatively, a step after the step A is further included:

A1. delivering a second sampling timing signal in a cable network line;

a step after the step B is further included:

B1. picking up an interference signal in the upstream detection point for the second time, sampling the interference signal, and associating a digital sample sequence of the interference signal obtained by sampling with a moment when a second sampling timing signal reaches the upstream detection point or with a transmitting moment when it is transmitted at the upstream detection point;

a step after the step C is further included:

C1. selecting a second downstream detection point downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when the second sampling timing signal reaches the second downstream detection point, or with a transmitting moment when it is transmitted at the second downstream detection point;

Step D further includes steps of:

D1: adjusting the digital sample sequence as described in step C or the digital sample sequence as described in step C1 so that the two sample sequences have the same amplitude value;

D2. In the two digital sample sequences which have the same amplitude value, calculating a cross-correlation function of the digital sample sequence as described in step C and the digital sample sequence as described in step B, and calculating a cross-correlation function of the digital sample sequence as described in step C1 and the digital sample sequence as described in step B1;

Step E further includes a step of:

determining presence of impairment sources each in signal delivering paths passing through the downstream detection points as described respectively in step C and step C1, based on a condition that cross-correlation peaks caused by the impairment sources in each case exist in two cross-correlation function graphs obtained by calculating the cross-correlation functions as described in step D2; and

steps after the step E are further included:

F. from the two cross-correlation function graphs, selecting a cross-correlation peak only caused by the impairment source in the signal delivering path passing through the downstream point as described in step C, and a cross-correlation peak only caused by the impairment source in a signal delivering path passing through the downstream point as described in step C1 respectively;

G. ranking degrees of damages to the network service resulted from impairment sources in the two different signal delivering paths, based on an order of amplitude value of the cross-correlation peaks selected from the two cross-correlation function graphs as described in step F.

Alternatively, steps after the step E are further included:

F. selecting the cross-correlation peak only caused by the impairment source in the signal delivering path as described in step E in the cross-correlation function graph;

G. determining the location of the impairment source, based on a time delay value of the cross-correlation peak only caused by the impairment source in the signal delivering path as described in step E.

Alternatively, when the interference signal as described in step C is a reflection signal, step G further includes a step of:

determining the presence of the impairment source downstream of the downstream detection point, based on conditions that absolute values of differences between time delay values of the two cross-correlation peaks only caused by the impairment source in the signal delivering path as described in step E and the time delay value of the cross-correlation peak caused by the downstream detection point are the same, and the signs of these two time delay value are opposite.

Alternatively, when the interference signal as described in step C is an external interference signal or a common path distortion signal, step G further includes a step of:

determining the presence of the impairment source downstream of the downstream detection point, based on a condition that the position to which the time delay value of a cross-correlation peak only caused by the impairment source in the signal delivering path as described in step E corresponds is the downstream detection point.

Alternatively, when the interference signal as described in step C is an external interference signal or a common path distortion signal, a step after the step C is further included:

C1. selecting a second downstream detection point downstream of the cable network so that the second downstream detection point and the cable branch of the downstream detection point as described in step C do not belong to the same cable branch; picking up an interference signal in the second downstream detection point, sampling the interference signal, and associating a digital sample sequence of the interference signal obtained by sampling with a moment when the sampling timing signal reaches the second downstream detection point;

a step after the step D is further included:

D1. calculating a cross-correlation function of the digital sample sequence as described in step B and the digital sample sequence as described in step C1;

a step after the step E is further included:

E1. determining presence of an impairment source in a signal delivering path passing through the second downstream detection point based on a condition that a cross-correlation peak caused by the impairment source exists in a cross-correlation function graph obtained by calculating the cross-correlation function as described in step D1; and

Step F further includes a step of:

based on a condition that the spacing between the pair of the cross-correlation peaks in one graph is the same as the spacing between the pair of the cross-correlation peaks in the other graph, determining presence of a cross-correlation peak only caused by the impairment source in the signal delivering path as described in step E and presence of a parasitic cross-correlation peak in the cross-correlation function graph as described in step E; determining presence of a cross-correlation peak only caused by the impairment source in the signal delivering path as described in step E1 and presence of a parasitic cross-correlation peak in the cross-correlation function graph as described in step E1; and determining that the position relationship between the pair of the cross-correlation peaks in one graph is opposite to the position relationship between the pair of the cross-correlation peaks in the other graph.

Alternatively, when the interference signal as described in step C is an external interference signal or a common path distortion signal, a step after the step A is further included:

A1. delivering a second sampling timing signal in a cable network line;

a step after the step B is further included:

B1. picking up an interference signal in the upstream detection point for the second time, sampling the interference signal, and associating a digital sample sequence of the interference signal obtained by sampling with a moment when a second sampling timing signal reaches the upstream detection point or with a transmitting moment when it is transmitted at the upstream detection point;

a step after the step C is further included:

C1. selecting a second downstream detection point downstream of the cable network so that the second downstream detection point and the cable branch of the downstream detection point as described in step C do not belong to the same cable branch; picking up an interference signal in the second downstream detection point, sampling the interference signal, and associating a digital sample sequence of the interference signal obtained by sampling with a moment when the second sampling timing signal reaches the second downstream detection point, or with a transmitting moment when it is transmitted at the second downstream detection point;

a step after the step D is further included:

D1. calculating a cross-correlation function of the digital sample sequence as described in step Bland the digital sample sequence as described in step C1;

a step after the step E is further included:

E1. determining presence of an impairment source in a signal delivering path passing through the second downstream detection point based on a condition that a cross-correlation peak caused by the impairment source exists in a cross-correlation function graph obtained by calculating the cross-correlation function as described in step D1; and

Step F further includes a step of:

based on a condition that a spacing between the pair of the cross-correlation peaks in one graph is the same to a spacing between the pair of the cross-correlation peaks in the other graph, determining presence of a cross-correlation peak only caused by the impairment source in the signal delivering path as described in step E and presence of a parasitic cross-correlation peak in the cross-correlation function graph as described in step E; determining presence of a cross-correlation peak only caused by the impairment source in the signal delivering path as described in step E1 and presence of a parasitic cross-correlation peak in the cross-correlation function graph as described in step E1; and determining that the position relationship between the pair of the cross-correlation peaks in one graph is opposite to the position relationship between the pair of the cross-correlation peaks in the other graph.

Alternatively, a step after the step F is further included:

in the cross-correlation peaks which have the same spacing in the two graphs, calculating a ratio of amplitude of two cross-correlation peaks in each of graphs, respectively; based on the two ratios of amplitude, determining that one of cross-correlation peaks in each graph is the cross-correlation peak only caused by the impairment source in the signal delivering path as described in step E, or is the cross-correlation peak only caused by the impairment source in the signal delivering path as described in step E1.

Alternatively, Step D further includes steps of:

D21: adjusting the digital sample sequence as described in step C or the digital sample sequence as described in step C1 so that the two sample sequences have the same amplitude value;
D22. Calculating respectively cross-correlation functions of each of the digital sample sequences which have the same amplitude value and the digital sample sequence as described in step B;

a step after the step F is further included:

in the two pairs of cross-correlation peaks which have the same spacing in the graph as described in step E and in the graph as described in step E1, determining that a cross-correlation peak with the largest amplitude is the cross-correlation peak only caused by the impairment source in the signal delivering path as described in step E, or is the cross-correlation peak only caused by the impairment source in the signal delivering path as described in step E1.

Alternatively, Step D further includes steps of:

D31: adjusting the digital sample sequence as described in step C or the digital sample sequence as described in step C1 so that the two sample sequences have the same amplitude value;
D32. in the two digital sample sequences which have the same amplitude value, calculating a cross-correlation function of the digital sample sequence as described in step C and the digital sample sequence as described in step B, and calculating a cross-correlation function of the digital sample sequence as described in step C1 and the digital sample sequence as described in step B1; and

a step after the step F is further included:

in the two pairs of cross-correlation peaks which have the same spacing in the graph as described in step E and in the graph as described in step E1, determining that a cross-correlation peak with the largest amplitude is the cross-correlation peak only caused by the impairment source in the signal delivering path as described in step E, or is the cross-correlation peak only caused by the impairment source in the signal delivering path as described in step E1.

BRIRF DESCRIPTION OF THE DRAWINGS

FIG.1 is a block diagram of a system for locating impairment sources in a cable network;
FIG.2(A)~(E) are schematic diagrams illustrating different location relationships between impairment sources and detection points;
FIG.3(A) is a schematic diagram illustrating an interference signal at an impairment source;
FIG.3(B) is a schematic diagram illustrating an interference signal at an upstream detection point in the condition shown in FIG.2(A);
FIG.3(C) is a schematic diagram illustrating an interference signal at a downstream detection point in the condition shown in FIG.2(A);
FIG.3(D) is a schematic diagram illustrating a sampling area signal in FIG.3(B);
FIG.3(E) is a schematic diagram illustrating a sampling area signal in FIG.3(C);
FIG.3(F) is a function graph obtained by calculating cross-correlation of digital sample sequences of the signals each shown in FIG.3(D) and FIG.3(E), wherein a horizontal axis is the difference value of the sampling serial numbers;
FIG.3(G)is a function graph formed by converting the horizontal axis in FIG.3(F) to a time axis;
FIG.4-1(A) is a schematic diagram illustrating an interference signal in a sampling area at an upstream detection point in the condition shown in FIG.2(C);

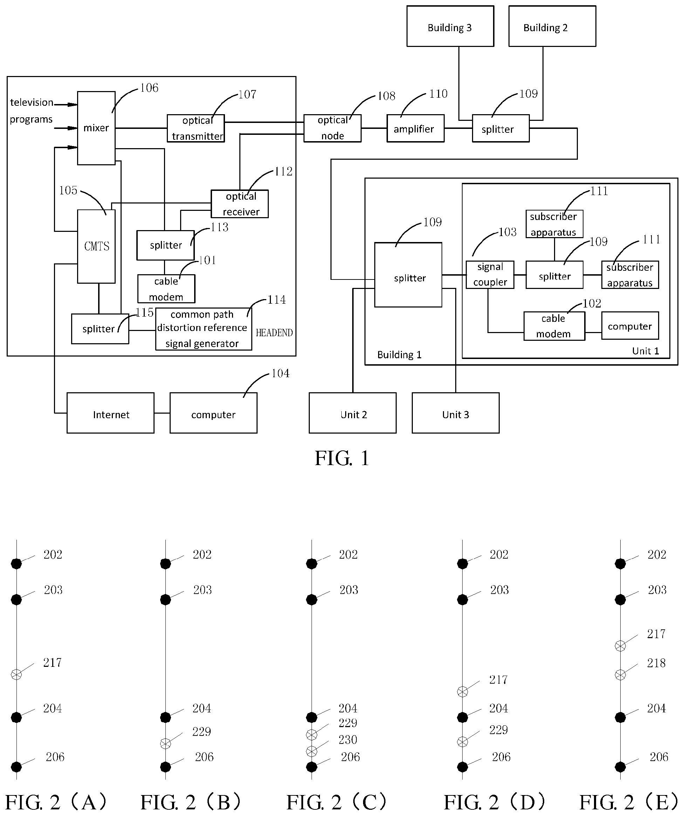

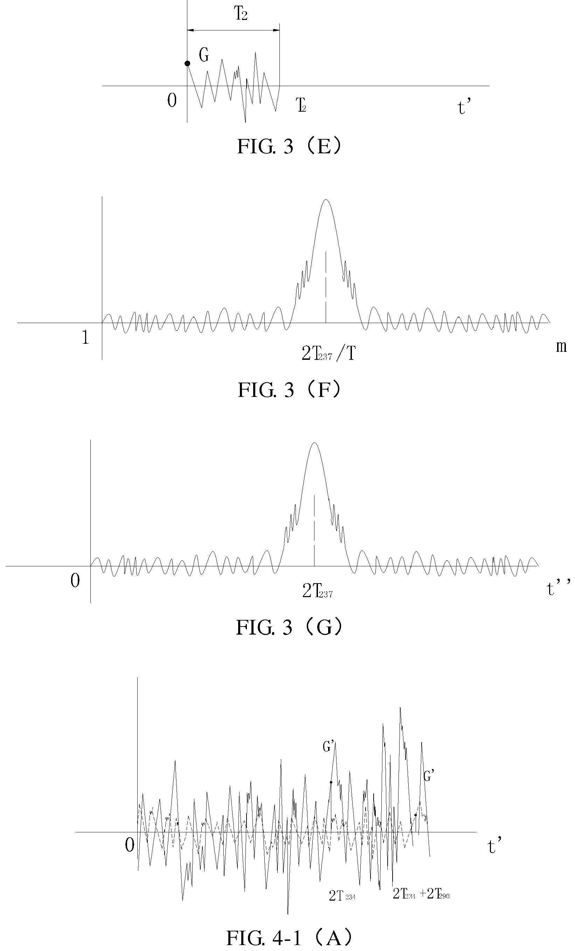

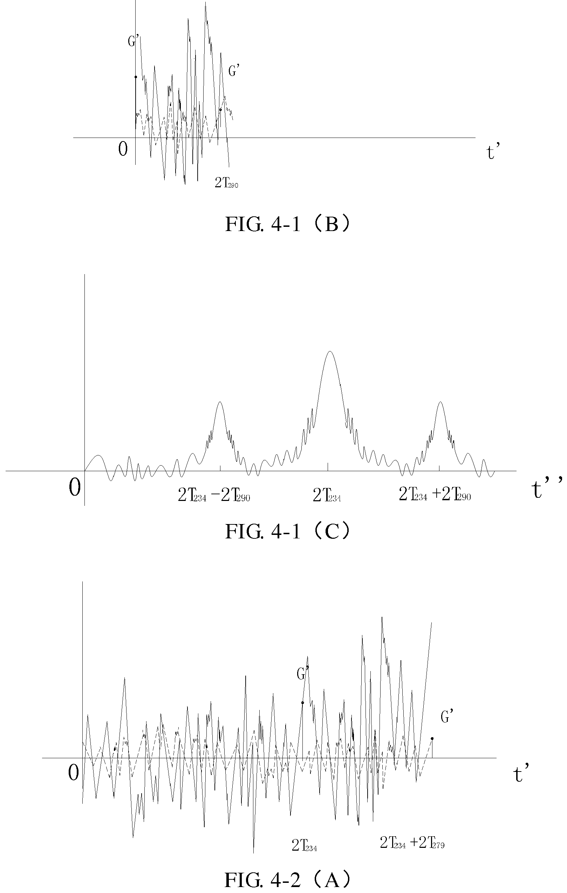

FIG.4-1(B) is a schematic diagram illustrating an interference signal in a sampling area at a downstream detection point in the condition shown in FIG.2(C);
FIG.4-1(C) is a function graph obtained by calculating cross-correlation of digital sample sequences of the signals each shown in FIG.4-1(A) and FIG.4-1(B);

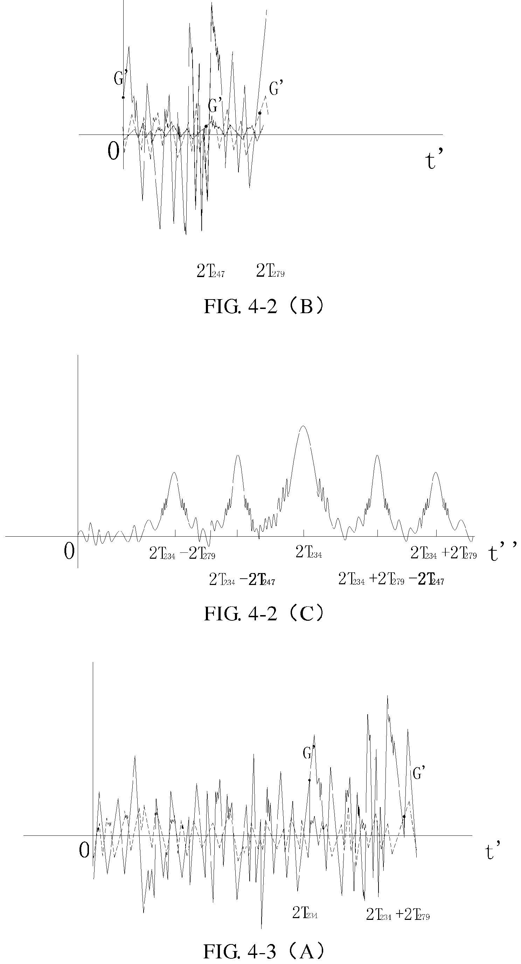

FIG.4-2(A) is a schematic diagram illustrating an interference signal in a sampling area at an upstream detection point in the condition shown in FIG.2(D);
FIG.4-2(B) is a schematic diagram illustrating an interference signal in a sampling area at a downstream detection point in the condition shown in FIG.2(D);
FIG.4-2(C) is a function graph obtained by calculating cross-correlation of digital sample sequences of the signals each shown in FIG.4-2(A) and FIG.4-2(B);

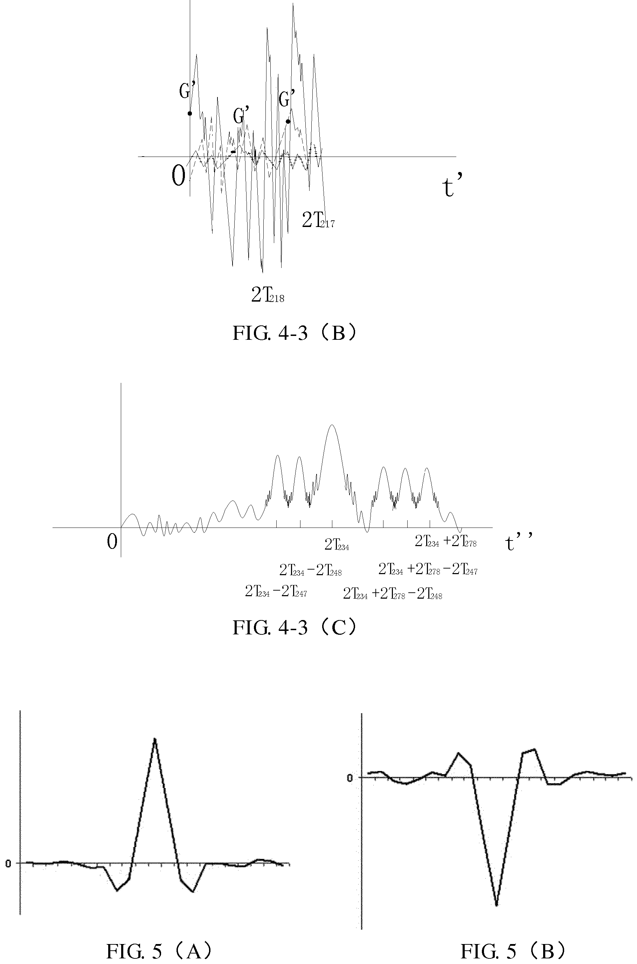

FIG.4-3(A) is a schematic diagram illustrating an interference signal in a sampling area at an upstream detection point in the condition shown in FIG.2(E);
FIG.4-3(B) is a schematic diagram illustrating an interference signal in a sampling area at a downstream detection point in the condition shown in FIG.2(E);
FIG.4-3(C) is a function graph obtained by calculating cross-correlation of digital sample sequences of the signals each shown in FIG.4-3(A) and FIG.4-3(B);
FIG.5(A)~(H) are schematic diagrams each illustrating cross-correlation peaks of QAM signal when the phase difference between the sample points of two modems is in 0°,180°, +22.5°, -22.5°, +45°, -45°, +90°, and-90°, respectively;

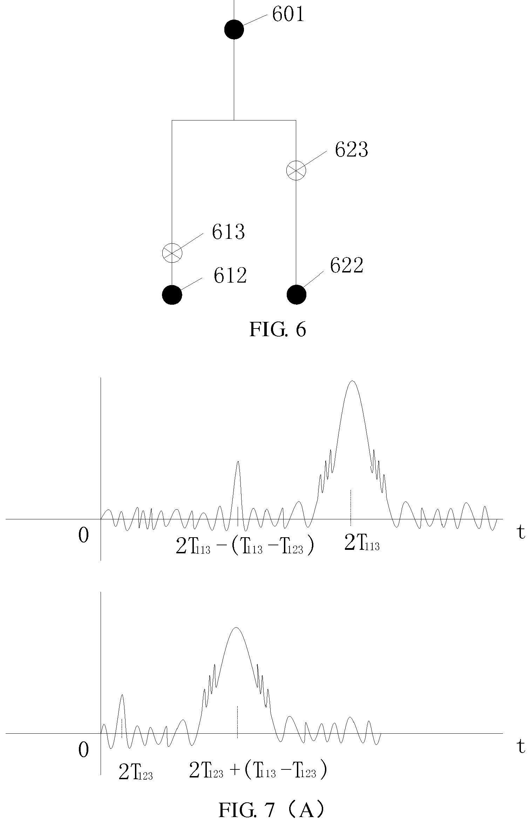

FIG.6 is a schematic diagram illustrating location relationship between impairment sources and detection points in two cable branches.
FIG.7 (A) is a graph of cross-correlation functions of two branches when signals from one inference source reach simultaneously at impairment sources in the two branches, in the condition shown in FIG.6;

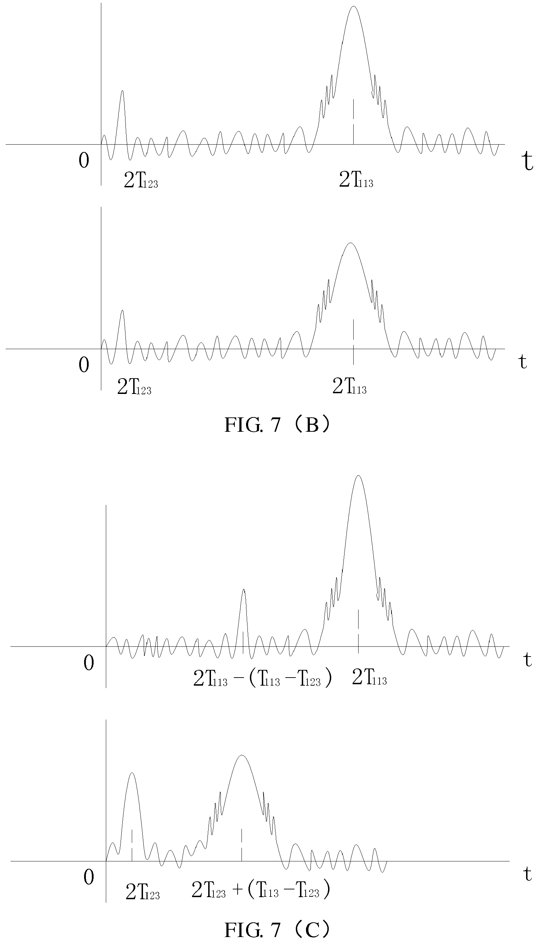

FIG.7 (B) is a graph of cross-correlation functions of two branches when a signal from one inference source first reaches a first branch, in the condition shown in FIG.6;
FIG.7(C) shows a function graph after changing of amplitude of a cross-correlation peak, based on FIG.7 (A), after independent signal products are respectively added in two impairment sources shown in FIG.6.

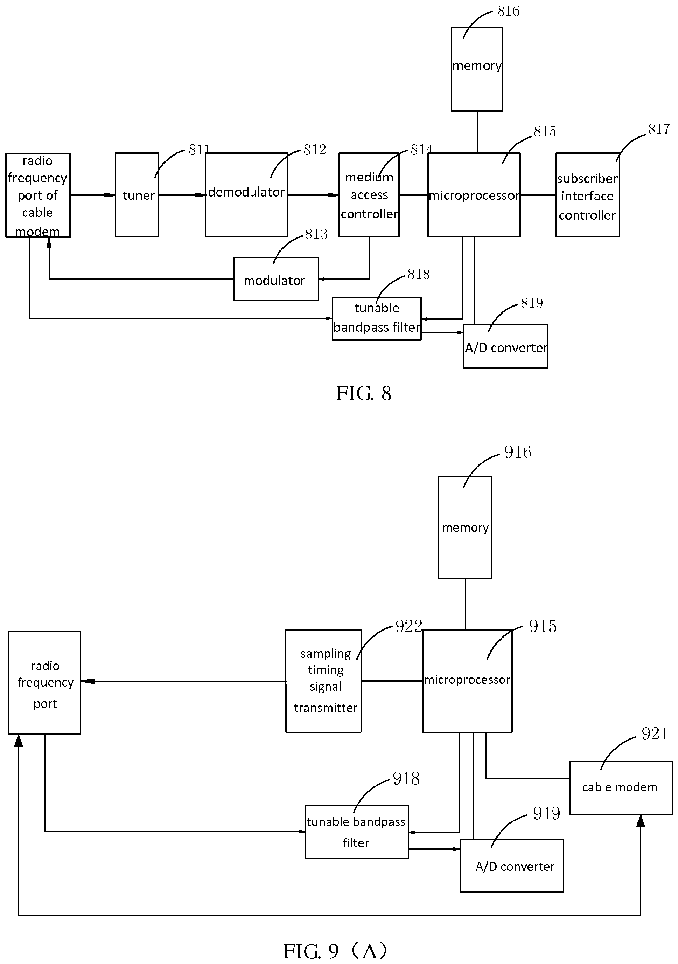

FIG.8 is a block diagram of the cable modem;

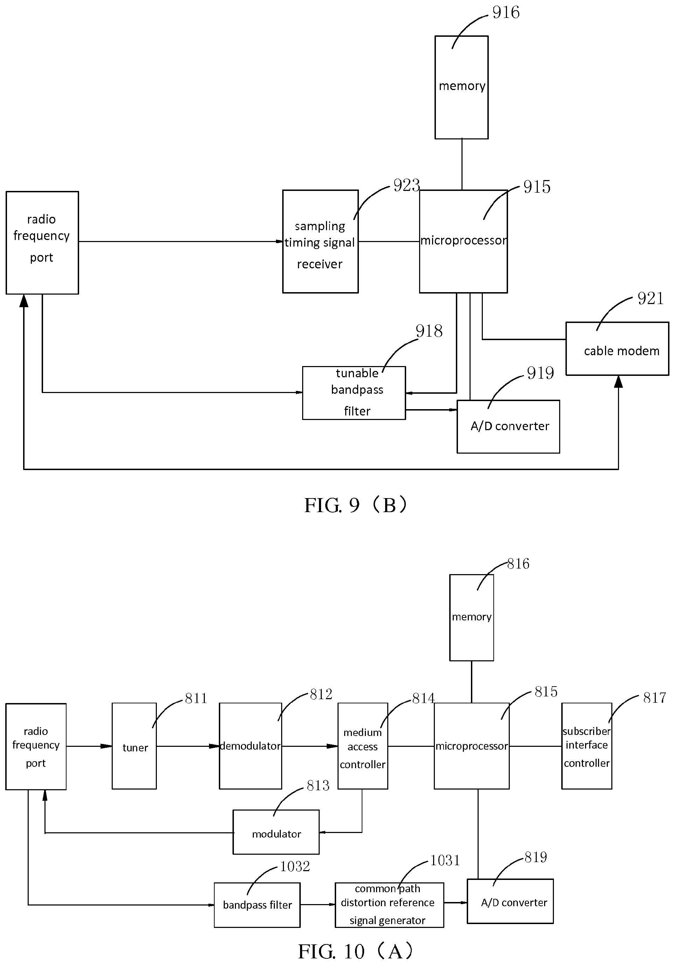

FIG.9 (A) and FIG.9 (B) are block diagrams illustrating two embodiments of an interference signal recorder respectively;

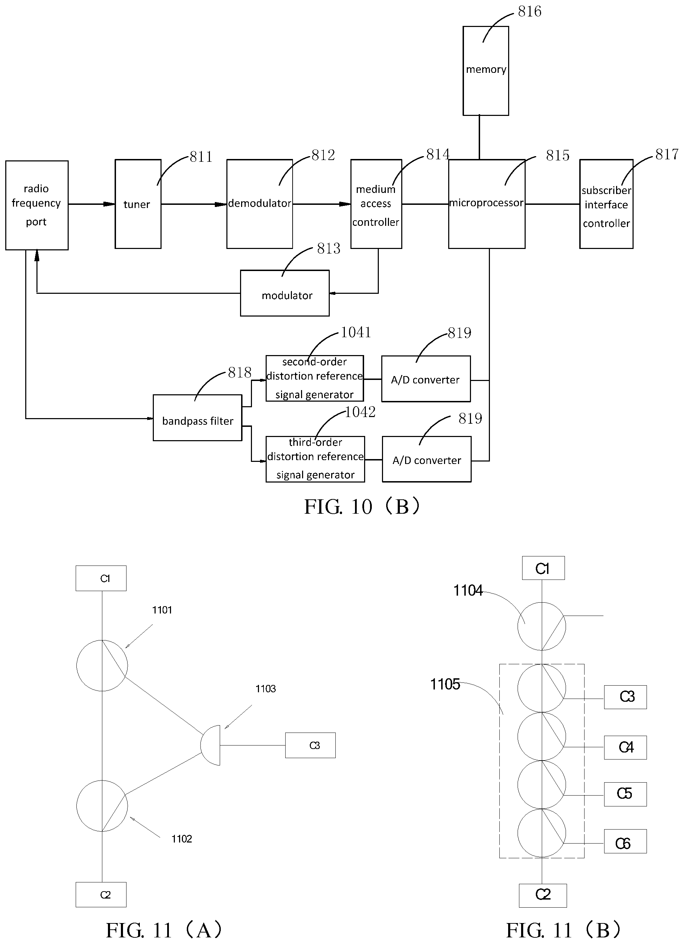

FIG.10 (A) and FIG.10 (B) are block diagrams illustrating two embodiments of a common path distortion reference signal recorder respectively;

FIG.11 (A) and FIG.11 (B) are electrical schematic diagrams illustrating two embodiments of a signal coupler respectively;

DETAILED DESCRIPTION OF THE PREFERRED EMBODIMENT

FIG.1 is an embodiment of a system for locating impairment sources in a cable network according to the invention. In the figure, a splitter 113, a cable modem 101, a splitter 115, and a common path distortion reference signal recorder 114 which are installed on a headend of a cable network; a signal coupler 103 installed in a cable branch of the cable network and a cable modem 102 installed at a terminal for locating impairment sources; and a computer 104 accessing the Internet for locating impairment sources, are devices added in order to constitute the present system. Other parts in the figure are a simplified cable network.

Signals in each of network channels and a downstream channel signal transmitted by a cable modem termination system (CMTS) 105 are mixed into downstream signals through a mixer 106. One branch of the downstream signals is sent to the cable modem 101 for locating impairment sources via the splitter 113; another branch of the downstream signals is sent to the common path distortion reference signal generator 114 via the splitter 115; a third branch of downstream signal reaches different subscriber apparatuses 111 of different subscribers via an optical transmitter 107, an optical node 108, an amplifier 110, splitters 109, a signal coupler 103 and further via a splitter 109. The downstream signal also reaches the cable modem 102 for locating impairment sources via the signal coupler 103, wherein the cable modem 102 can serve as a subscriber apparatus at the same time. The downstream signals also reach every other cable branch. Upstream service signals transmitted by the cable modem 102 and by each of the subscriber apparatuses 111 firstly reach the optical node 108 in a reversed direction through the paths of downstream signals via the cable lines and then reach an optical receiver 112 via optical fiber lines. One branch of the upstream signals outputted from the optical receiver 112 reaches the cable modem termination system (CMTS) 105 via the splitter 113. The upstream signal transmitted by the common path distortion reference signal generator 114 is also sent to the cable modem termination system (CMTS) 105 via the splitter 115. The cable modem termination system (CMTS) 105 accesses the Internet. The cable modems 101, 102 and the common path distortion reference signal generator 114 are brought into communication with the computer 104 through the cable modem termination system (CMTS) 105 and the Internet.

In accordance with the above-mentioned signal transmission path, interference signals produced in the whole signal transmission path which passes the signal coupler 103, including interference signals produced in the downstream line thereof and interference signals produced in the upstream line thereof, in any case reach the cable modem 101 on the headend along the transmission path of the upstream service signals. The interference signals produced in other cable branches in the downstream of the optical node 108 also reach the cable modem 101 on the headend along the respective paths. Thus, all the interference signals produced in the whole coaxial cable networkcoaxial coaxial cable network reach the cable modem 101 on the headend. The interference signals produced downstream of the signal coupler 103 reach the cable modem 102 downstream along the transmission path of the upstream signals. The interference signals produced upstream of the signal coupler 103 reach the cable modem 102 along the transmission path of the downstream signals, but interference signals produced in each of cable branches which connect with upstream line of the signal coupler 103 do not reach the cable modem 102. In this way, only the interference signals produced in the signal transmission path passing through installation location of the signal coupler 103 can reach the cable modem 102 in this cable branch.

The cable modems 101 and 102 each have a sampler which samples the interference signal delivered to the respective cable modem. An instruction containing specific encoding of a certain synchronous message which is expected to be transmitted soon by the cable modem terminate system (CMTS) 105 is sent by the computer 104 to the cable modems 101 and 102 via the Internet. The specific encoding is regarded by the cable modems 101 and 102 as identification criterion for identifying the specific encoding from the signals transmitted hereafter by the cable modem terminate system (CMTS) 105. Once the specific encoding is received, sample values of the interference signals sampled hereafter are stored in a memory, in order to form digital sample sequences of the interference signals. The digital sample sequences of the interference signals provided by the two cable modems 101 and 102 are received by the computer 104 via the Internet. A cross correlation function graph can be obtained by the computer 104 which calculates a cross correlation function of the two digital sample sequences. If there is a cross-correlation peak caused by an impairment source in the cross correlation function graph, it could be determined that the impairment source exists in the signal transmission path passing through the signal coupler 103 installation location.

The signal couplers 103 and the cable modems 102 are installed in a plurality of cable branches respectively so as to cover all the cable branches, which results in performing locating of impairment sources over the whole coaxial cable network. Further, the installation of the signal couplers 103 can be set as a locating base point. The upstream service signal or the interference signal produced in the downstream line of the signal couplers 103 is used as a test signal. A time delay value of the cross correlation peak in the cross correlation function graph, corresponding to installation location of the signal couplers 103, is measured. The cable length from the impairment source to the signal couplers 103 can be calculated in accordance with a time delay value of the cross correlation peak of the impairment source and the time delay value of the cross correlation peak of the signal couplers 103.

By the common path distortion reference signal recorder 114, the downstream signal is picked up and used to generate the common path distortion reference signal sampled in the same way as the mentioned cable modem in order to obtain a digital sample sequence of the reference signal. When locating an impairment source where the common path distortion reference signals are produce, the digital sample sequence of the reference signals is used by the computer 104 to engage in calculation of cross correlation function in order to obtain a more reliable locating result.

FIG.2 is a schematic diagram illustrating location relationships between impairment sources and detection points. In the figure, in terms of positions, points from upstream to downstream are a common path distortion reference signal recording point 202, an upstream detection point 203, a downstream detection point 204 and a test signal transmitting point 206 respectively.

In FIG.2, the downstream signals and a sampling timing signal are delivered from upstream to downstream. At the common path distortion reference signal recording point 202, a digital sample sequence of the reference signals can be obtained by sampling by means of a common path distortion reference signal recorder; at the upstream interference signal detection point 203, a digital sample sequence of interference signals from the downstream of the point can be obtained by sampling the interference signals by means of a signal coupler and a reference signal recording device; at downstream interference signal detection point 204, a digital sample sequence of interference signals from upstream and downstream of the point can be obtained by sampling the interference signals by means of a signal coupler and a reference signal recording device; at test signal transmitting point 206, a test signal can be transmitted by means of a test signal generator.

In FIG.2 (A), the impairment source 217 is upstream of the downstream detection point 204. $T_{237}$ denotes the channel time delay from upstream detection point 203 to the impairment source 217; $T_{247}$ denotes the channel time delay from downstream detection point 204 to the impairment source 217. Let a sampling timing signal be transmitted from upstream to downstream, assuming the sampling timing signal reaches the upstream detection point 203 at the moment to , it will reach the impairment source 217 at the moment $t_0+T_{237}$ , and will reach the downstream detection point 204 at the moment $t_0+T_{237}+T_{247}$.

At the moment when the sampling timing signal reaches the impairment source 217, denoting a interference signal produced in this impairment source as a reference point G of the signal. In downstream direction, the point G in the signal is delivered in parallel with the sampling timing signal, and after the time delay $T_{247}$, reaches the downstream detection point 204 together with the sampling timing signal at the moment $t_0+T_{237}+T_{247}$. In upstream direction, after time delay $T_{237}$, the point G reaches the upstream point 203 at the moment $t_0+2T_{237}$, the time delay $2T_{237}$ later than the moment when the sampling timing signal arrives.

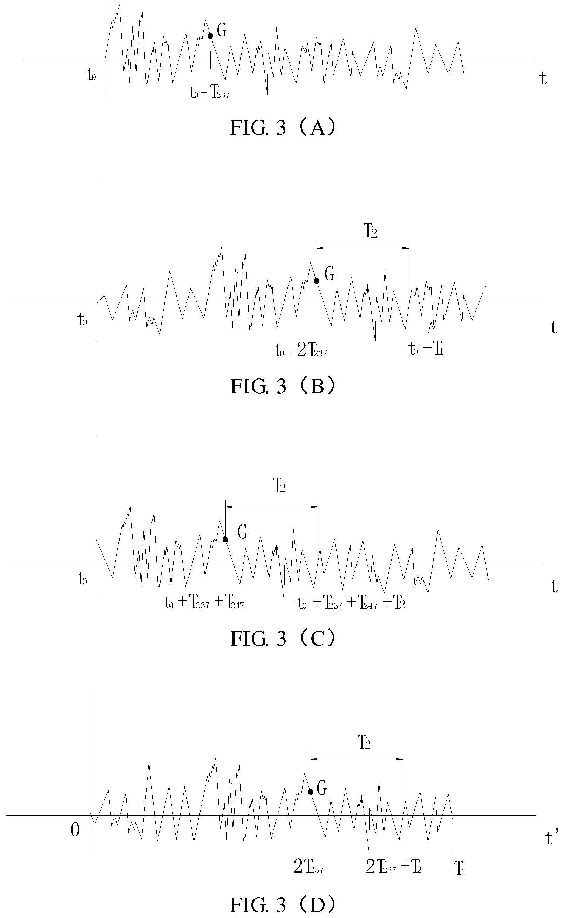

The FIG.3 (A), 3(B) and 3(C) each show the interference signals respectively at the impairment source 217, the upstream detection point 203 and the downstream detection point 204. At the moment to when the sampling timing signal reaches the upstream detection point 203, the interference signal begins to be sampled at the upstream detection point 203. Assuming the sampling duration at the upstream detection point 203 is $T_1$, the finishing moment of sampling at the point 203 is to+Ti. In FIG.3 (B), the signal in a range from moment to to to+Ti is a sampling area signal at the upstream detection point 203. Set the beginning moment of sampling at the upstream detection point 203 to be moment 0 of the sampling area, the resulting sampling area signal at the upstream detection point 203 shown in FIG.3 (D) can be obtained. At the moment $t_0 +T_{237}+T_{247}$, when the sampling timing signal reaches the downstream detection point 204, the interference signal begins to be sampled at the said downstream detection point. Assuming the sampling duration at the downstream detection point is $T_2$, the finishing moment of sampling at the downstream detection point is $t_0+T_2$. In FIG.3(C), the signal in a range from $t_0 +T_{237}+T_{247}$ to time $t_0+T_2$ is a sampling area signal at the downstream detection point 204. Set the beginning moment of sampling at the downstream detection point 204 to be moment 0 of the sampling area, the resulting sampling area signal at the downstream detection point 204 is shown by FIG.3 (E).

Set the digital sample sequence obtained by sampling at the downstream detection point 204 as x(n), and the digital sample sequence obtained by sampling at the upstream detection point 203 as y(n). In that, n is a sampling serial number representing each sampling value in each sequence. For the sequence x(n), the value range of n is 1 to L, wherein 1 and L are sampling serial numbers representing sampling values respectively at moment 0 and $T_2$ in FIG.3(E). For the sequence y(n), the value range of n is 1 to P, wherein 1 and P are sampling serial numbers representing sampling values respectively at moment 0 and $T_1$ in FIG.3(D); when sampling period is T, the relationship between the sampling serial number n and time values of time axes in FIG.3(D) and FIG.3(E) is n/T+1.

The expression of cross correlation function of sequence x(n) and y(n) is:

$$Rxy\ (m) = \sum_{n=1}^{L} x(n)y(n+m) \quad (\text{ Formula } 1).$$

In this expression, n+m is not greater than P. With regard to each value of m, its function value Rxy(m) is a value accumulating all products which is obtained by multiplying orderly and respectively by each of No.1 sample value to No.L sample value in the sequence x(n), i.e. each of sample values of the sequence x(n), and corresponding one of No.1+m sample value to No.L+m sample value in the sequence y(n), i.e. corresponding one of the sample values of the sequence y(n) which is in a sample sequence section having the same number of sample values as the sequence x(n).

Wherein, m is a difference value between the sample serial number of each sample value in the section of the sequence y(n) engaging in shift-and-add multiplication and the sample serial number of each sample value in the sequence x(n) engaging in shift-and-add multiplication. As seen in FIG.3(D) and 3(E), the signal from moment 0 to moment $T_2$ in FIG.3(E) is remarkably similar to the signal from moment $2T_{237}$ to moment $2T_{237}+T_2$ in FIG.3(D). Thus the sample value of sample sequence section which has sampling serial numbers from sample sequence No.$2T_{237}$/T+1 to No.$(2T_{237}+T_2)$/T+1 in the digital sample sequence y(n) have strong cross correlation to the all sample values of the sequence x(n). In this case, the cross correlation function Rxy(m) has a maximum value. That is to say, in the cross correlation function graph, a cross correlation peak would appear at a position where the difference m between two sets of serial numbers of sample values engaging in the correspondingly shift-and-add multiplication is ($2T_{237}$/T+1) -1. Whereas, when m is a value other than ($2T_{237}$/T+1) -1, no cross correlation peak would appear for the reason that sample sequence sections of the sequence y(n) are not correlated to the sequence x(n). FIG.3 (F) is a cross-correlation function graph, wherein the horizontal axis is the difference m between two sets of serial numbers of sample values engaging in the correspondingly shift-and-add multiplication. Each of the value m in the horizontal axis in FIG.3 (F) is multiplied by the sampling period T so as to make the horizontal axis into a time axis. FIG.3 (G) is a cross-correlation function graph in which the horizontal axis is the time axis. As shown in FIG.3 (G), the cross correlation peak is in the position corresponding to time delay $2T_{237}$. $2T_{237}$ is precisely the double of the channel time delay $T_{237}$ which is from the impairment source 217 to the upstream detection point 203.

The channel time delay in the upstream optical fiber line relating to the impairment source in the cable network can be calculated by using the channel time delay obtained in aforesaid method as well as the collected optical fiber length and the signal transmission velocity parameter in the optical fiber, and then the channel time delay in the upstream cable line relating to the impairment source can be obtained. The cable length from the impairment source to the optical node can be further calculated by using the signal transmission velocity parameter in the cable. If the channel time delay in the cross correlation function graph is ignored, it could be determined whether there is a impairment source existing between the upstream detection point 203 and the downstream detection point 204 only in accordance with whether there is a cross correlation peak existing in the cross correlation function graph.

In FIG.2(B), an impairment source 229 is downstream of the downstream detection point 204. In this case, the interference signals are produced from the impairment source 229. When the interference signals reach the downstream detection point 204, one branch of the signals are sampled at this point, meanwhile another branch of the signals continues to be delivered toward the upstream detection point 203. These two branches of signals can be regarded as signals delivered from this downstream detection point toward directions of two detection points simultaneously. As such, the effect to the interference signal by the downstream detection point is the same to the process to the interference signal produced in the impairment source 217 of FIG.2 (A). Thus, by the aforesaid method of locating process, after calculating a cross correlation function, a cross correlation peak would appear at a position corresponding to the double of the channel time delay from the downstream detection point 204 to the upstream detection point 203. When such result occurs, it is determined that there is an impairment source existing downstream of the downstream detection point 204. Obviously, with regard to the impairment source existing downstream of the downstream detection point, such locating result only shows a region where this impairment source located. If the range of the region is desired to be narrowed, it is needed to move the downstream detection point further toward downstream.

The cable length obtained in the described locating process may contain the following errors: an error caused by inconsistency between time delay characteristics of the upstream signal channel and the downstream signal channel, an error caused by inconsistency between responding speeds of two cable modems in the upstream and the downstream to sample timing signals, and an error in the signal transmission velocity parameter. When calculating the channel time delay of the optical fiber, there is also a data error in the optical fiber length. In the actual line of a cable network, when an upstream cable modem is installed upstream of the optical fiber line, measurement data of the optical fiber length usually contain large errors due to the large length of optical fiber line. Furthermore, in the actual line, the length of connecting cables of the upstream cable modem also need to be measured so that a channel time delay thereof is included in the total channel time delay for locating, otherwise errors would be introduced. Locating accuracy for the system is reduced due to these errors.

Assuming that the downstream detection point 204 is set to be a locating base point, a signal which is from downstream can be delivered by this downstream detection point to the direction of the upstream detection point 203. And assuming that a test signal is transmitted from the test signal transmitting point 206 to upstream direction, the test signal is treated as an interference signal. In accordance with the aforesaid locating method, a total length of the optical fiber and the cable from the downstream detection point 204 to the upstream detection point 203 can be obtained and denoted by $S_{234}$, wherein a locating error included is denoted by $\Delta S_{234}$. Therefore an accurate total length of the optical fiber and the cable is $S_{234}$-$\Delta_{S234}$.

Set the locating result relating to the impairment source 217 as the total length of the optical fiber and the cable from the impairment source 217 to the upstream detection point 203, it is denoted by $S_{237}$, which includes a locating error denoted by $\Delta S_{237}$. Therefore an accurate total length of the optical fiber and the cable is $S_{237}$-$\Delta S_{237}$.

By subtracting the accurate total length of the optical fiber and the cable from the impairment source 217 to the upstream detection point 203 i.e., $S_{237}$-$\Delta S_{237}$, from the accurate total length of the optical fiber and the cable from the downstream detection point 204 to the upstream detection point 203 i.e., $S_{234}$-$\Delta S_{234}$, an accurate length of the cable from the impairment source 217 to the downstream detection point 204 i.e., $(S_{234}$-$\Delta S_{234})$ - $(S_{230}$-$\Delta S_{230})$ is obtained. In view of extremely small difference between $\Delta S_{S234}$ and $\Delta S_{230}$, the accurate length of the cable from the impairment source 217 to the downstream detection point 204 is $S_{234}$-$S_{237}$. Thus, the locating error part $\Delta S_{237}$ is eliminated in this expression.

During locating process, the channel time delay from the impairment source to the locating base point can be calculated directly by means of the difference between time delay value of the cross correlation peak of the impairment source and the time delay value of the cross correlation peak of the locating base point. Line data in the upstream of the locating base point is not necessary to be used in present method, resulting in reduction in collection workload of line data. Also, the combined signal of the interference signal with the testing signal at the locating base point can be recorded. Thus a locating error possibly introduced by difference the between sampling times of the testing signal and the interference signal can be further eliminated.

In the system shown in FIG.1, it is convenient to set the location of the signal coupler 103 as the locating base point. As soon as arriving at the signal coupler 103, upstream service signals transmitted from the subscriber apparatuses downstream of the signal coupler 103 or the interference signals produced in the impairment source are delivered from the signal coupler 103 toward the cable modem on the headend and the cable modem at the terminal simultaneously. Using this characteristic of the signal coupler 103, the upstream service signals transmitted from the subscriber apparatuses downstream of the signal coupler 103 or the external interference signal produced in the impairment source can be used as a testing signal so that a testing signal generator is avoided, which simplifies measuring process of the locating base point.

Furthermore, when the signal coupler 103 has a function reflecting signals toward the cable modem 102 in the downstream, the upstream service signal transmitted from the cable modem 102 in the downstream can act as a testing signal, with the location of the signal coupler 103 being the locating base point.

The aforesaid method can be applied to locating impairment sources of any type of interference signals including external interference signals, common path distortion signals and reflection signals.

Due to the generally small amplitude of the common path distortion signals, it is difficult to identify cross-correlation peaks of the common path distortion signals in the case that cross-correlation peaks caused by other signals exist. An improved measure is to use a common path distortion reference signal recorder. The common path distortion reference signal recorder picks up the downstream signals in the cable network, and generates the second-order distortion products and the third-order distortion products of the downstream signals which are used as the reference signals. Digital sample sequences of the common path distortion reference signals are obtained by sampling the reference signals. A cross-correlation function of the sample sequences of the common path distortion reference signals with the sample sequences of the interference signals obtained by sampling by the cable modem in the downstream is calculated, and then a cross-correlation function graph is obtained. Base on presence or absence of a cross-correlation peak in the cross-correlation function graph, presence or absence of an impairment source on the corresponding signal transmission path can be determined. In the case of presence of the cross-correlation peak, the location of the impairment source on the line can be ascertained by calculating the cross-correlation of the digital sample sequence of the reference signals with the digital sample sequence of the interference signals sampled in the upstream.

In FIG.2 (A), the impairment source 217 is upstream of the downstream detection point 204. When arriving at the common path distortion reference signal recording point 202, a signal point of the downstream signals which are delivered parallel to the sampling timing signal can generate a signal point of the common path distortion reference signals, a signal at this generated point is recorded as a first sample value in the digital sample sequence of the reference signals. At another moment, the signal point of the downstream signals and the sampling timing signal parallel thereto reach the impairment source 217, at which a signal point of the interference signals corresponding to the signal point of the downstream signals is produced. A signal at the signal point of the interference signals is recorded as a first sample value in the digital sample sequence of the interfere signals in the downstream when arriving, in parallel to the sampling timing signal, at the downstream detection point 204. Obviously, a cross-correlation function of the sample sequence of the interference signals with the sample sequence of the interfere signals in the downstream can be calculated and time delay value of a cross-correlation peak in the cross-correlation function graph thereof should be 0.

In FIG.2 (B), an impairment source 229 is downstream of the downstream detection point 204. After arriving at the downstream detection point 204, a signal point of the downstream signals which are delivered parallel to the sampling timing signal continues to be delivered toward the impairment source 229 in the downstream. When arriving at the impairment source 229, the signal point of the downstream signals which are delivered parallel to the sampling timing signal produces a signal point of the interference signal. The signal point of the interference signal is delivered toward upstream. The moment when the signal point of the interference signal reaches the downstream detection point 204 is later than the moment when sampling timing signal reaches. This lagging duration is the double of the channel time delay from the downstream detection point 204 to the impairment source 229. In the digital sample sequence of the interference signal, the sampling serial number of the sample value of the signal at the signal point of the interference signal is definitely greater than 1. Thus this sequence is referred to x(n), and the digital sample sequence of the reference signals is referred to y(n). The cross-correlation function of these two sequences is calculated by Formula 1. The time delay value of the cross-correlation peak thereof is a negative value, its absolute value is the double of the channel time delay from the downstream detection point 204 to the impairment source 229.

In the situation shown in FIG.2 (B), in which the impairment source 229 is downstream of the downstream detection point 204, instead of the aforesaid sample sequence of the interference signal in the downstream during locating process, the sample sequence of the reference signals is applied together with the sample sequence of the interference signals in the upstream to calculate a cross-correlation function. The location of a cross-correlation peak in the cross-correlation function graph obtained thereby is slightly different from the location obtained through calculating directly the two sequences of both interference signals. In this case, the time delay of the cross-correlation peak caused in the impairment source 229 downstream of the downstream detection point 204 is not equal to the double of the channel time delay from the upstream detection point 203 to the downstream detection point 204, but equal to the double of the channel time delay from the upstream detection point 203 to the impairment source 229.

When locating an impairment source which produces common path distortion signal, either a positive peak and a negative peak in cross-correlation function graphs in any case should be regarded as a valid cross-correlation peak. As mentioned, the origin of producing the common path distortion signal is due to a non-linear relationship between the voltage applied to the impairment source and the current passing through the impairment source. Such non-linear relationship illustrates a non-linear relationship between the impedance of the impairment source and the voltage applied to the impairment source. Obviously, this variation of impedance caused by the different voltages applied makes an incident signal at the impairment source produce reflection signals with different amplitudes. From perspective of energy transmission, the energy of the incident signal which does not pass through the impairment source is the energy reflected in the impairment source. Thus, if the amplitude of the downstream signal in a certain polarity direction is compressed after passing through the impairment source, the amplitude of the reflection signal in the same polarity direction would be increased. Thus, taking the impairment source as the center, the common path distortion signals which are delivered along the cable in two directions have opposite polarities. In the situation shown in FIG.2 (A), the impairment source 217 is upstream of the downstream detection point 204. Signals arriving respectively at the upstream detection point 203 and the downstream detection point 204 have opposite polarities, resulting in a negative cross-correlation peak in the cross-correlation function graph. In the situation shown in FIG.2 (B), the impairment source 229 is downstream of the signal coupler 204. Signals arriving respectively the upstream detection point 203 and the downstream detection point 204 have the same polarity, resulting in a positive cross-correlation peak in the cross-correlation function graph.

When locating the impairment source producing a reflection signal, a testing signal is used for testing a reflection point; both of the testing signal, which is a direct signal, and the reflection signal are regarded as interference signals delivered from the impairment source. In FIG.2 (A), assuming that the testing signal is transmitted by a testing signal transmitting point 206, when the testing signal reaches the impairment source 217, a reflection signal and the keep-going direct signal are simultaneously delivered from the impairment source 217 toward two directions, respectively. Obviously, the locating result of the impairment source is the same to the aforesaid locating result as long as the direct testing signal is regarded as the interference signal.

Due to the use of the testing signal, when the impairment source is an impairment source producing a reflection signal, it may exist another cross-correlation peak in the cross-correlation function graph in addition to the aforesaid cross-correlation peak caused by the impairment source. For example, in FIG.2 (A), when the testing signal is transmitted from the testing signal transmitting point 206, the direct testing signal can reach both of the downstream detection point 204 and the upstream detection point 203. Thus, a cross-correlation peak, which is not caused by the impairment source, is formed in the cross-correlation function graph by the direct testing signal, its time delay value is the double of the channel time delay from the upstream detection point 203 to the downstream detection point 204.

The amplitude of the direct testing signals respectively arriving at the upstream detection point 203 and downstream detection point 204 is much greater than the amplitude of the reflection signals such that the amplitude of the cross-correlation peak caused by the direct testing signals is much greater than the amplitude of cross-correlation peak caused by the impairment source. Accordingly, the cross-correlation peak caused by the direct test signal can be easily identified. Further, if the downstream detection point 204 is set as the locating base point, the time delay value of the cross-correlation peak caused by the direct test signal would be equal to the time delay value corresponding to the locating base point. Therefore, such cross-correlation peak can be identified more easily.

Whether or not a cross-correlation peak is caused by an impairment source which produces a reflection signal, as well as the locations and quantity of the cross-correlation peaks are also in relation to the relative locations of the impairment source and the testing signal source. In FIG.2 (B), the impairment source 229 is downstream of the downstream detection point 204. When a testing signal is transmitted by the testing signal transmitting point 206, the signal reflected from the impairment source 229 is only delivered to the testing signal transmitting point 206 and does not reach the upstream detection point 203 and downstream detection point 204 such that the impairment source 229 cannot cause a cross-correlation peak in the cross-correlation function graph. When a testing signal is transmitted from the downstream detection point 204, the signals reflected from the impairment source 229 can reach the downstream detection point 204 and upstream detection point 203 such that the impairment source can cause a plurality of cross-correlation peaks in the cross-correlation function graph.

When there are two impairment sources producing reflection signals in the line, locations of the cross-correlation peak are not dependent on each of these two impairment sources, separately. In FIG.2(C), both of impairment sources 229 and 230 are in the downstream of the downstream detection point 204. Set the moment when the sample timing signal reaches the upstream point 203 as to, the time delay from the upstream detection point 203 to the downstream detection point 204 as $T_{234}$, such that the moment when the sample timing signal reaches the downstream detection point 204 is $t_0+T_{234}$. Set the testing signal transmitting point 206 transmits a testing signal, and set a signal in testing signals arriving at the downstream detection point 204 at the moment $t_0+T_{234}$ as a point G' of the signal. In the diagram of the sampling area signal at the upstream detection point 203, the signal point G' is in a position corresponding to $2T_{234}$; in the diagram of the sampling area signal at the downstream detection point 204, the signal point G' is in a position corresponding to 0. Set the channel time delay from the impairment source 229 to the impairment source 230 as $T_{290}$. The moments when a reflection signal, which has experienced reflection at the impairment source 229 for the first time and reflection at the impairment source 230 for the second time, reaches respectively at the upstream point 203 and the downstream point 204 lag for the time delay $2T_{290}$, as compared with the moments when the direct signal reaches respectively at each of the detection points. Thus, in the diagram of the sampling area signal at the upstream detection point 203, the point G' of the reflection signal which is reflected for the second time is in a position corresponding to $2T_{234}+2T_{290}$; in the diagram of the sampling area signal at the downstream detection point 204, the point G' of the reflection signal which is reflected for the second time is in a position corresponding to $2T_{290}$. The two sampling area signals are respectively shown in FIG.4-1(A) and FIG.4-1(B), in these figures, the signal reflected for the first time and the signal reflected for the second time are respectively indicated by a solid line and a dashed line. The cross-correlation function graph of digital sample sequences of the two sampling area signals is shown in FIG.4-1(C).

In FIG.4-1(C), there is a cross-correlation peak caused in the downstream detection point 204, the time delay value thereof is $2T_{234}$. This time delay value is equal to time difference between the point G' of the direct signal in FIG.4-1(A) and the point G' of the direct signal in FIG.4-1(B). Each of the other cross-correlation peaks is respectively a cross-correlation peak having a time delay value $2(T_{234}-T_{290})$ which is equal to time difference between the point G' of the direct signal in FIG.4-1(A) and the point G' of the reflection signal in FIG.4-1(B); a cross-correlation peak having a time delay value $2(T_{234}+T_{290})$ which is equal to a time difference between the point G' of the reflection signal in FIG.4-1(A) and the point G' of the direct signal in FIG.4-1(B). In FIG.4-1(C), the two cross-correlation peaks caused by reflection signals reflected from the impairment sources locate on the sides of the cross-correlation peak caused by the detection point respectively and have the same spacing from the cross-correlation peak caused by the detection point.

A cross-correlation peak should have been caused by the time difference between the point G' of the reflection signal in FIG. 4-1(A) and the point G' of the reflection signal in FIG. 4-1(B). However, due to the small amplitude of the two reflection signals and the consistency between the position of the cross-correlation peak thereby on the time axis and the position of the cross-correlation peak caused by the detection point, such cross-correlation peak fails to be shown in the graph.

In FIG.2 (D), the impairment source 217 is upstream of the downstream detection point 204, the impairment source 229 is downstream of the downstream detection point 204. Set the channel time delay from the downstream detection point 204 to the impairment source 217 as $T_{247}$, and the channel time delay from the impairment source 217 to the impairment source 229 as $T_{279}$. According to analysis of the aforesaid method, the sampling area signal diagram of the upstream detection point 203 as shown in FIG.4-2(A) can be obtained; the sampling area signal diagram of the downstream detection point 204 as shown in FIG.4-2(B) can be obtained; the corresponding cross-correlation function graph as shown in FIG.4-2(C) can be obtained. Comparing FIG.4-2(A) with FIG.4-1(A), the lagging duration of the reflection signal reflected for the second time change to $2T_{279}$ with respect to the direct signal. Comparing FIG.4-2(B) with FIG.4-1(B), in addition to that the lagging duration of the reflection signal reflected for the second time change to $2T_{279}$ with respect to the direct signal, a reflection signal which is reflected by the impairment source 217 for the first time is added, point G' of this reflection signal is in the position of $2T_{247}$, indicated by a solid line with circles on it. Comparing FIG.4-2(C) with FIG.4-1(C), two cross-correlation peaks caused by the reflection signals reflected for the first time by the impairment source 217 are added, wherein one of the cross-correlation peaks has the time delay value $2(T_{234}-T_{247})$ which is equal to a time difference between the point G' of the direct signal in FIG.4-2(A) and the point G' of the reflection signal reflected for the first time in FIG.4-2(B); and the other cross-correlation peak has the time delay value is $2(T_{234}+ T_{279}-T_{247})$ which is equal to a time difference between the point G' of the reflection signal reflected for the second time in FIG.4-2(A) and the point G' of the reflection signal reflected for the first time in FIG.4-2(B).

In FIG.2 (E), both of impairment sources 217 and 218 are upstream of the downstream detection point 204. Set the channel time delays from the downstream detection point 204 to the impairment sources 217 and 218 as $T_{247}$ and $T_{248}$ respectively, and the channel time delay from the impairment source 217 to the impairment source 218 as $T_{278}$. According to analysis of the aforesaid method, the sampling area signal diagram of the upstream detection point 203 as shown in FIG.4-3(A) can be obtained; the sampling area signal diagram of the downstream detection point 204 as shown in FIG.4-3(B) can be obtained; the corresponding cross-correlation function graph as shown in FIG.4-3(C) can be obtained. Comparing FIG.4-3(A) with FIG.4-2(A), the lagging duration of the reflection signal reflected for the second time changes to $2T_{278}$ with respect to the direct signal. Comparing FIG.4-3(B) with FIG.4-2(B), a reflection signal which has experienced reflection for the first time is added in FIG.4-3(B), the added reflection signal in FIG.4-3(B) is indicated by a solid line with circles on it, and a reflection signal which has experienced reflection for the second time is eliminated. This is because the signal reflected for the second time via the impairment source 218 is not reflected to the downstream of the impairment source, but the signals reflected for the first time at the two impairment sources are in any case reflected to the downstream. Comparing FIG.4-3(C) with FIG.4-2(C), a cross-correlation peak is added, and there are not any cross-correlation peaks having the same spacing anymore. This is resulted from that no reflection signal is delivered from downstream of the downstream detection point 204 to the detection point.

As understood from above, according to the condition that there are cross-correlation peaks which have the same spacing from and located on the both sides of the cross-correlation peak which is caused at the downstream detection point 204, it can be determined that there is an impairment source in the downstream of the detection point.

Using the same method, it can be analyzed that another group of results in relation to the position relationship between cross-correlation peaks in the cross-correlation function graph when the downstream detection point 204 transmits a testing signal, can be achieved. But still, according to the condition that there are cross-correlation peaks which have the same spacing from and located on the both sides of the cross-correlation peak which is caused at the downstream detection point 204, it can be determined that there is an impairment source in the downstream of the detection point.

As mentioned, the upstream service signal of the subscriber apparatus can be used as the testing signal for detecting reflection points. However, the upstream service signal used at present is mainly a QAM signal. When every symbol of the QAM signal is treated as a basic signal unit, the QAM (Quadrature Amplitude Modulator) signal can be regarded as a stochastic signal. But the signal is a deterministic signal in duration of each symbol and a single frequency carrier signal having a frequency which is the transmitting carrier frequency of the upstream service signal. In this way, during sampling respectively by the two cable modems in the upstream and downstream, if a position of a signal is a sample point of one cable modem, usually this position of the signal would not be a sample point of the other cable modem. A phase difference exists between a sample point of the other cable modem closest to the position of the signal and said sample point of the one cable modem, with respect to the transmitting carrier frequency of the upstream service signal. After the position of the signal, the phase differences between each pair of sample points of the two cable modems at every time successive sampling is performed separately by the two cable modem are also the same. This inconsistency of the sampling point with respect to the position of the signal causes the phase difference between sample points of the two cable modems with respect to the carrier frequency of the upstream service. When the phase difference between sample points is approximately 90°, a function value of the cross-correlation function graph in a position where a cross-correlation peak most possibly appears is approximately zero; at the time, on one side of this position in the cross-correlation function graph, there are certainly several cross-correlation function values which are not approximately zero at the positions of time with difference of one or two equivalent sampling period and within the range in which the furthest position of time does not exceed duration of one symbol. The same situation occurs in the other side of the position where a cross-correlation peak most possibly appears in the cross-correlation function graph. A cross-correlation peak area graph in which the phase difference of the sample points is 90° is therefore obtained by connecting these function values to form a curve. When the values of phase differences between sample points of the two modems are other values, the shapes of cross-correlation peak area graphs are different from each other.

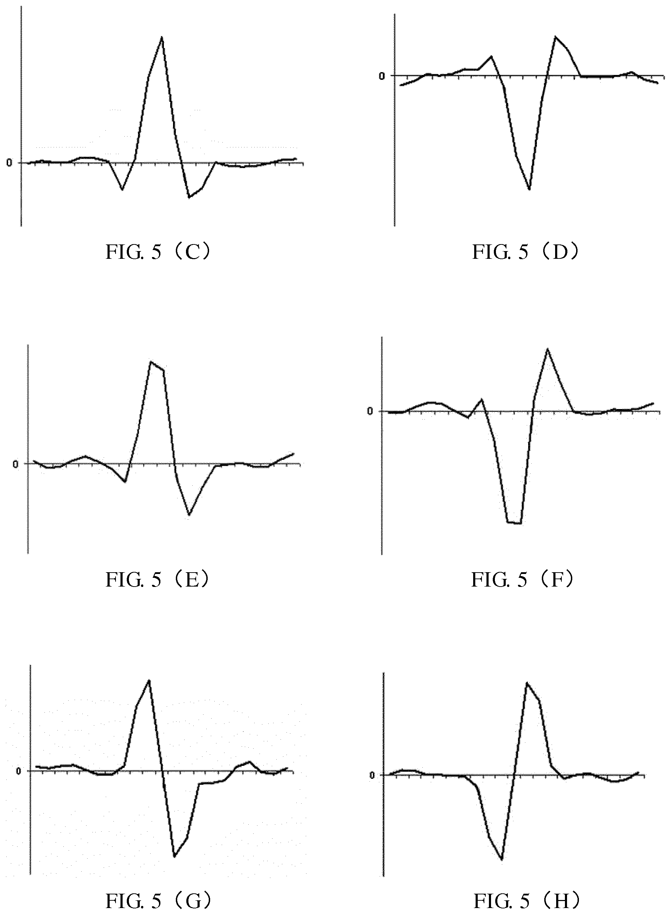

In a case that the phase differences between the sample points of the two modems are constant, the parameters affecting the shape of the cross-correlation peak area graph are carrier frequency of the QAM signal, symbol frequency of modulation signal and sampling frequency of the sampler. In a laboratory environment, a group of cross-correlation peak graphs with different values of phase differences between sample points of the two modems can be collected by means of actual used signals and sampler parameters. During locating process, accurate time delay values of the cross-correlation peaks can be obtained by comparing the graphs obtained in locating process with laboratory graphs. Also, the laboratory graphs can be obtained by means of computer simulation. FIG.5(A) to 5(H) of FIG.5 show cross-correlation peak graphs by means of computer simulation, when the phase differences between the sample points of two modem are 0°,180° , +22.5°, -22.5°, +45°, -45°, +90°and -90°, respectively.

Furthermore, the ratios of amplitude of the laboratory graph characteristic points in the case that phase differences between the sample points of the two modems are different and amplitude in a case that the phase differences between the sample points of two modems are 0°, can be calculated. The amplitudes of cross-correlation peaks in cases that the phase differences between the sample points of the two modems are different, can be normalized into amplitudes with a common phase difference by means of these ratios, so that the cross-correlation peaks of different phase differences can be compared in relation to the amplitudes.

When the interference signals with the same product are produced at impairment sources in the different signal delivering paths, in the cross-correlation function graph of each of branches, apart from presence of a cross-correlation peak individually caused by the impairment source in the signal delivering path via a downstream detection point in present branch, there are parasitic cross-correlation peaks caused by impairment sources in other signal delivering paths. It is necessary to identify these two types of cross-correlation peaks in the process for ascertaining location of an impairment source in the line by means of time delay values of the cross-correlation peaks.

FIG.6 is a schematic diagram illustrating location relationships between impairment sources and detection points in two cable branches. In the figure, location 601 is an upstream detection point, location 612 is a detection point of a first cable branch, and 622 is a detection point of a second cable branch. 613 and 623 are impairment sources respectively in the first cable branch and the second cable branch, and each of them is upstream of the detection point of each branch. Set the channel time delay from the upstream detection point 601 to the impairment source 613 of the first branch as $T_{113}$, and the channel time delay from the upstream detection point 601 to the impairment source 623 of the second branch as $T_{123}$. Each of impairment sources of branches is located in accordance with the aforesaid method. In a function graph of the first branch, a time delay value of the cross-correlation peak caused by the impairment source in this branch is $2T_{113}$. In a function graph of the second branch, a time delay value of the cross-correlation peak caused by the impairment source in this branch is 2T123.

Assuming there is an interference source in the surroundings, and signals from the interference source reach the two impairment source 613 and 623 of the branches at the same time. In the first branch, the interference signal reaches upstream detection point when the delivering time delay $T_{113}$ elapses; in the second branch, the interference signal reaches upstream detection point when the delivering time delay $T_{123}$ elapses. The time difference between time delays of the signals in both branches is $T_{113}$-$T_{123}$. As mentioned, the time delay value of the cross-correlation peak of the second branch is $2T_{123}$. Assuming that $T_{113}$ is greater than $T_{123}$, and the signal in the second branch thus first reaches the upstream detection point, a parasitic cross-correlation peak in the function graph of the second branch caused by the signal from the first branch is in a position corresponding to $2T_{123}$+($T_{113}$-$T_{123}$). Similarly, a parasitic cross-correlation peak in the function graph of the first branch caused by the signal from the second branch is in a position corresponding to $2T_{113}$-($T_{113}$-$T_{123}$). Assuming that the aforesaid interference source is the only interference source in the surroundings, the cross-correlation function graphs of the two branches are shown in FIG.7 (A). As seen from the figure, the spacing of the cross-correlation peaks in each graph is equal; the position of cross-correlation peak of the present branch is opposite to the position of the parasitic cross-correlation peak in the two graphs. Among the 4 cross-correlation peaks in the two graphs, the cross-correlation peaks corresponding respectively to the greatest time delay value and the least time delay value, each are the cross-correlation peak caused by the impairment source of the present branch of each of graphs.

However, a time difference between the moments when a signal from the external interference source is respectively delivered to the two impairment sources, actually and certainly exists, which affects the time delay values of parasitic cross-correlation peaks. Therefore, the determination that the cross-correlation peaks corresponding respectively to the greatest time delay value and the least time delay value in cross-correlation function graphs of the two branches are the cross-correlation peaks caused by the impairment sources of the present branches may be wrong. Due to the random distribution of the time difference with respect to the magnitude and the sign, the more difference between the channel time delays individually from the two impairment sources to the upstream point is, the higher accuracy of determination is.

If the signal from the interference source first reaches the impairment source 623 of the second branch and then reaches the impairment source 613 of the first branch, the time difference is $T_{113}$-$T_{123}$, then the time difference between the times when the interference signals of the two branches reach the upstream detection point is $2(T_{113}$-$T_{123})$, as shown in two graphs in FIG.7 (B). In these two graphs, a time delay value of a parasitic cross-correlation peak in one graph is equal to a time delay value of a cross-correlation peak caused by the impairment source of the present branch in the other graph. That is the case of common path distortion signals which are not produced by a common interference source but rather are produced respectively at the two impairment sources by a signal from a common signal source.

Additionally, the relationship between the time delay values of cross-correlation peaks when two impairment sources existing a common branch can be explained. If two impairment sources produce external interference signals, containing signals with the same product, the position relationship of the cross-correlation peaks is equal to the position relationship of cross-correlation peaks resulted from overlap of the two graphs in FIG.7 (A). If the impairment sources produce common path distortion signals, the position relationship of the cross-correlation peaks is equal to the position relationship of cross-correlation peaks resulted from overlap of the two graphs in FIG.7(B).

In the cross correlation function graphs 7(A), the ratio of amplitude of the cross-correlation peaks respectively with the small time delay value and with the large time delay value in the graph of the first branch should be equal to the ratio of amplitude in the graph of the second branch. This is because it has been assumed that the interference signals of two branches arriving at the upstream point are identical. The ratios of amplitude of cross-correlation peaks in the two graphs are dependent on the ratios of amplitude of the signals. However, in the actual network, the external interference signals entering the network from the impairment sources of the two branches in any case contain signal products independent on each other. The amplitude of the cross-correlation peak caused by the impairment source of the first branch in FIG.7 (A) is increased due to the independent signal product in the first branch; the amplitude of the cross-correlation peak caused by the impairment source of the second branch in FIG.7 (A) is increased due to the independent signal product in the second branch. The amplitude of the parasitic cross-correlation peaks in these two graphs is invariable with presence of the independent signal products. For this reason, the ratios of amplitude of the actual cross-correlation peaks in the two graphs calculated on basis of the aforesaid method are not equal any more. In the graph with the larger ratio, the cross-correlation peak with the small time delay value is the cross-correlation peak caused by the impairment source of the present branch. The actual cross-correlation graphs of the two branches are shown in FIG.7(C).

In terms of the impairment source producing external interference signals, another method for identifying a cross-correlation peak caused by an impairment source in the present branch is that adjusting amplitude values of the digital sample sequences obtained by sampling from the two branches into the same value; and then calculating their cross-correlation function. If one digital sample sequence is x(n), the value range of n is 1 to L, the amplitude value of the sequence is $\left( \sum_{n=1}^{L} x(n)^2 \right)^{1/2}$. In FIG.6, assuming that the digital sample sequences obtained by sampling from the first branch and the second branch are xa(n) and xb(n) respectively, the value range of n is 1 to L. The method for adjusting amplitude values of the two value sequences into the same value is calculating the amplitude values of the two sequences; setting the ratio of the amplitude value of the first sequence and the amplitude value of the second sequence as a coefficient; multiplying every sample value in the second sequence by this coefficient. Thus, the amplitude value of the second sequence multiplied by the coefficient is consistent with the amplitude value of the first sequence. Cross-correlation functions of the two digital sample sequences and an upstream digital sample sequence are calculated respectively. Therefore, the amplitude relationship of the cross-correlation peaks between the two cross-correlation graphs is not affected by inconsistency of the amplitude values of the two digital sample sequences in the downstream, thereby it can be determined that among two pair of cross-correlation peaks having the same spacing in the two cross-correlation graphs, one cross-correlation peak with the largest amplitude is the cross-correlation peak caused by the impairment source in the branch.

The products of the common path distortion signals in the two branches which are substantially the same, mainly include second-order distortion products and the third-order distortion products of the downstream signals, wherein the ratios of amplitude of each distortion term are of a difference, such that amplitudes of the parasitic cross-correlation peaks in graphs each are smaller than amplitudes without such a difference. Thus, the cross-correlation peak in the graph can be identified by means of the method for processing the external interference signals.

Another method for identifying a cross-correlation peak caused by an impairment source in the present branch is that generating two common path distortion reference signals by a downstream signal, wherein one of the reference signals is a second-order distortion product, the other one is a third-order distortion product; sampling two reference signals respectively to obtain two corresponding digital sample sequences. Cross-correlation functions of each of the two digital sample sequences and the digital sample sequence of the interference signal sampled in the upstream are calculated in order to obtain a cross-correlation function graph with a second-order distortion product as well as a cross-correlation function graph with a third-order distortion product. Ratios of amplitude of the cross-correlation peaks corresponding to the same time delay value in the two graphs are calculated. Cross-correlation functions of each of the two digital sample sequences and the digital sample sequence of the interference signal sampled in the first branch are calculated in order to obtain a cross-correlation function graph with a second-order distortion product as well as a cross-correlation function graph with a third-order distortion product. A ratio of amplitude of the cross-correlation peaks in the two graphs is calculated. Then, cross-correlation functions of each of the two digital sample sequences and the digital sample sequence of the interference signal sampled in the second branch are calculated in order to obtain a cross-correlation function graph with a second-order distortion product as well as a cross-correlation function graph with a third-order distortion product. A ratio of amplitude of the cross-correlation peaks in the two graphs is calculated. Comparing the ratio of amplitude of cross-correlation peaks between the two downstream graphs in the first branch with the ratios of amplitude of cross-correlation peaks between the two upstream graphs, and then selecting the closest ratio of cross-correlation peaks of the two upstream graph to the ratio of amplitude of cross-correlation peaks between the two downstream graphs in the first branch; comparing the ratio of amplitude of cross-correlation peaks between the two downstream graphs in the second branch with the ratios of amplitude of cross-correlation peaks between the two upstream graphs, and selecting the closest ratio of cross-correlation peaks of the two upstream graph to the ratio of amplitude of cross-correlation peaks between the two downstream graphs in the second branch. And then, a pair of ratios closest to each other from previously selected ratios is selected, wherein a time delay value of a cross-correlation peak represented by the ratio from the upstream graph is the time delay value corresponding to the impairment source in the downstream branch represented by the ratio from the branch.

The characteristic that the common path distortion signals being delivered in different directions from the impairment source have opposite polarities, contributes to identify the cross-correlation peak caused by the impairment source of the branch. When the impairment source is in the upstream of the detection points, signals each arriving at the upstream detection point and the downstream detection point have opposite polarities; when the impairment source is in the downstream of the detection points, signals each arriving at the upstream detection point and the downstream detection point have the same polarity. When calculating cross-correlation functions of sample sequences of interference signals each from one branch of upstream and one branch of downstream with the sample sequence of the reference signal, respectively, if the cross-correlation peaks in the upstream graph and the downstream graph both are positive peaks or negative peaks, signals arriving at the upstream and downstream detection points have the same polarity; otherwise, the signals have the opposite polarities.

The previously described method that adjusting amplitude values of the digital sample sequences into the same value and then calculating their cross-correlation function, can also be used for ranking degrees of damages to the network service which result from impairment sources in different cable branches. In different branches, comparing each of amplitudes of cross-correlation peaks caused by the impairment source of the present branch in each of the two graphs, if the relationship between the above amplitudes is not affected by the amplitude value of the digital sample sequence sampled in the downstream, the damage to the network service, that result from a impairment source by which amplitude of caused the cross-correlation peak is larger, wherein the impairment source is in a source branch in the downstream from which the sampled digital sample sequence involves in calculation of the cross-correlation function, is deeper.

Instead of each of the digital sample sequences of interference signals sampled in the downstream, the digital sample sequence of the reference signal obtained by sampling by the common path distortion reference signal generator is applied in calculation of cross-correlationsample sequence. Because the amplitude of the digital sample sequence of reference signal is constant naturally, degrees of damages to the network service resulting from impairment sources can be ranked according to the amplitudes of the cross-correlation peaks caused by the impairment sources in different cable branches respectively, after the identification of the cross-correlation peaks.

Another system is slightly different from the system shown in FIG.1 in that the two cable modems in FIG.1 are replaced with two interference signal recorders. One of the interference signal recorders with a sampling timing signal transmitter transmits a sampling timing signal to another interference signal recorder so that it is not necessary for the the interference signal recorder with transmitter to receive a sampling timing signal, and it is possible for the interference signal recorder to associate directly the digital sample sequence obtained by sampling with the transmitting moment when such interference signal recorder transmits the sampling timing signal. The signals transmitted from the cable modem termination system are no longer used as the sampling timing signal in this system.

FIG.8 is a block diagram of the cable modem for locating impairment sources. In this figure, in addition to a tuner 811, a demodulator 812, a modulator 813, a medium access controller 814, a microprocessor 815, a memory 816 and a subscriber interface controller 817, as included in a general cable modem, the cable modem further contains a tunable bandpass filter 818 and an A/D converter 819. A sampler is included in the A/D converter 819. A signal receiver is constituted by the tuner 811, the demodulator 812 and the medium access controller 814. Synchronous message signals delivered in the cable network line are received by the signal receiver. The tunable bandpass filter 818 having a variable center frequency and a variable bandwidth is connected to a radio frequency port of the cable modem such that the interference signals within a specific frequency range reach the A/D converter 819 via the tunable bandpass filter 818. The A/D converter 819 is used for sampling, quantizing and encoding the interference signal. By the microprocessor 815, instructions of the computer 104 are received via the Internet, the frequency and bandwidth of the tunable bandpass filter 818 are adjusted to wait for a signal which is provided by the medium access controller 814, wherein the signal is in relation to the moment when the specific encoding of a certain synchronous message expected to be transmitted by the cable modem terminate system (CMTS) 105 reaches. Once the signal is obtained by the microprocessor, the sample values of the interference signal obtained by sampling are stored in the memory 816.

FIG.9 (A) and FIG.9 (B) are block diagrams illustrating two embodiments of an interference signal recorder. In these figures, the microprocessor 915, a memory 916, a tunable bandpass filter 918 and an A/D converter 919 have the same functions as 815, 816, 818 and 819 in FIG.8. The sampling timing signal transmitter 922 in FIG.9 (A) is used to transmit sampling timing signals to the cable network line. In FIG.9 (A), the microprocessor 915 is connected with the sampling timing signal transmitter 922. Once the sampling timing signal is transmitted by the sampling timing signal transmitter 922, the sample values of the interference signal obtained by sampling are stored in the memory 916. The sampling timing signal receiver 923 in FIG.9 (B) is used to receive sampling timing signals from the cable network line. In FIG.9 (B), the microprocessor 915 is connected with the sampling timing signal receiver 923. Once the sampling timing signal is received by the sampling timing signal receiver 923, the sample values of the interference signal obtained by sampling are stored in the memory 916. A cable modem 921 included in each of FIG.9 (A) and FIG.9 (B) is used to build communication with the computer 104 for locating in the system.

FIG.10 (A) is a block diagram illustrating the first embodiment of one common path distortion signal recorder. Compared with FIG.8, a common path distortion signal generator 1031 is added in this figure. The tunable bandpass filter 818 in FIG.8 is replaced with a bandpass filter 1032 having a fixed frequency. And the connection of the bandpass filter 1032 with the microprocessor 815 is eliminated. Downstream signals are admitted to pass through the bandpass filter 1032. Common path distortion signals are generated from the downstream signal by the common path distortion signal generator 1031. The A/D converter 819 is used for sampling the reference signal.

FIG.10 (B) is a block diagram illustrating the second embodiment of another common path distortion signal recorder. A second-order distortion reference signal generator 1041 and a third-order distortion reference signal generator 1042 are included; the common path distortion signal generator 1031 in the first embodiment is eliminated. A second-order distortion product of the downstream signal is generated by the second-order distortion reference signal generator 1041; the third-order distortion product is generated by the third-order distortion reference signal generator 1042 of the downstream signal. The second-order distortion product and the third-order distortion product each are sampled by the A/D converter 819.

By the way of the characteristic that each of output ports of a tap cannot be separated sufficiently, the general tap can be used as a signal coupler. FIG.11(A) is a schematic diagram illustrating a signal coupler. In this figure, 1101 and 1102 are general taps in the cable network, 1103 is a general splitter; C1, C2, C3 are three ports of the signal couplers, an insertion loss between ports C1 and C2 is low, but insertion losses between ports C1 and C3, and between ports C2 and C3 are high. The ports C1 and C2 are used to connect the signal coupler in series to the line of cable network. The port C3 is used to connect to one end of the home-entry cable, and the other end of the home-entry cable is connected to cable modems and subscriber apparatuses.

FIG.11(B) is a schematic diagram illustrating another signal coupler. In this figure, 1104 is a tap which port is open or short; 1105 is a tap. In this figure, the port C1 is used to connect to the upstream cable, the port C2 is used to connect the downstream cable, the ports C3 to C6 are used to connect to the home-entry cable. A splitting port of the tap 1105 is open or short. When a signal enters into any one of ports C2 to C6, the signal is reflected by the open or short tap port of the tap 1105 to all ports C2 to C6. When the signal coupler is connected to the cable line, the cable modem for locating an impairment source can be installed on any one of subscriber ports.

In the system, a device performing calculation of cross-correlation functions can be a computer installed with software for calculation of cross-correlation functions, or a device combining a dedicated hardware with dedicated software.

The foregoing is only preferred embodiments of the present invention, which are not intended to limit the present invention, any modification, substitution and improvement made within the spirit and principles of the present invention, should be included within the protection scope of the present invention.

**Claims**

1. An interference signal recording device, **characterized in that** comprising:

   a radio frequency port for connecting to a cable line of a cable network;
   a signal receiver connected to the radio frequency port;
   a sampler connected to the radio frequency port;
   a microprocessor connected to the signal receiver and to the sampler, wherein the microprocessor is designed to associate a digital sample sequence of an interference signal obtained by sampling of the sampler with a moment when a sampling timing signal reaches the present device and is received by the signal receiver.

2. An interference signal recording device, **characterized in that** comprising:

   a radio frequency port for connecting to a cable line of a cable network;
   a signal transmitter connected to the radio frequency port;

a sampler connected to the radio frequency port;

a microprocessor connected to the signal transmitter and to the sampler, wherein the microprocessor is designed to associate a digital sample sequence of an interference signal obtained by sampling of the sampler with a transmitting moment when a sampling timing signal is transmitted by the signal transmitter.

3. A system for locating impairment sources in cable network, **characterized in that** comprising:

a common path distortion reference signal recorder connected to the cable network, which generates and samples a common path distortion reference signal, and associates a digital sample sequence of the reference signal obtained by sampling with a moment when a sampling timing signal delivered via the cable network line reaches said reference signal recorder, or with a transmitting moment when a sampling timing signal is transmitted from the reference signal recorder;

an interference signal recording device installed in the downstream of the cable network, which samples an interference signal in the cable network, and associates a digital sample sequence of the interference signal obtained by sampling with a moment when a sampling timing signal delivered via the cable network line reaches said device, or with a transmitting moment when a sampling timing signal is transmitted from the device;

an impairment source locating and calculating device connected to the interference signal recording device installed in the downstream and the common path distortion reference signal recorder by means of communication media, which calculates a cross-correlation function of the digital sample sequence of the common path distortion reference signal and the digital sample sequence of the interference signal.

4. The system according to claim 3, **characterized in that** comprising:

an interference signal recording device installed upstream of the cable network, which samples an interference signal in the cable network, and associates a digital sample sequence of the interference signal obtained by sampling with a moment when a sampling timing signal delivered via the cable network line reaches said device, or with a transmitting moment when a sampling timing signal is transmitted from the device; the interference signal recording device is connected with the impairment source locating and calculating device by means of the communication media; the locating and calculating device calculates a cross-correlation function of the digital sample sequence of the interference signal and the digital sample sequence of the common path distortion reference signal.

5. A system for locating impairment sources in cable network, **characterized in that** comprising:

an interference signal recording device installed upstream of the cable network, which samples an interference signal in the cable network, and associates a digital sample sequence of the interference signal obtained by sampling with a moment when a sampling timing signal delivered via the cable network line reaches said device, or with a transmitting moment when a sampling timing signal is transmitted from the device;

an interference signal recording device installed downstream of the cable network, which samples an interference signal in the cable network, and associates a digital sample sequence of the interference signal obtained by sampling with a moment when a sampling timing signal delivered via the cable network line reaches said device, or with a transmitting moment when a sampling timing signal is transmitted from the device;

an impairment source locating and calculating device connected to the interference signal recording device installed in the downstream and the interference signal recording device installed in the upstream by means of communication media, the impairment source locating and calculating device calculates a cross-correlation function of the digital sample sequence obtained by sampling of the interference signal recording device installed in the upstream and the digital sample sequence obtained by sampling of interference signal recording device installed in the downstream.

6. The system according to claim 3 or 5, **characterized in that** comprising:

a signal coupler connected between the interference signal recording device installed in the downstream and the cable line of the cable network, which couples interference signals each produced in the upstream and the downstream lines of the signal coupler to the interference signal recording device installed in the downstream.

7. A method for locating impairment sources in cable network, **characterized in that** comprising steps of:

A. transmitting a sampling timing signal to a cable network line;

B. selecting a detection point in the cable network, picking up a downstream signal in the detection point, generating a common path distortion reference signal by using the downstream signal, sampling the reference signal, and associating a digital sample sequence of the reference signal obtained with a moment when a sampling timing signal reaches the detection point or with a transmitting moment when it is transmitted at the detection point;

C. selecting a downstream detection point in the downstream of the cable network, picking up an interference signal at the downstream detection point, sampling the interference signal, and associating a digital sample sequence of the interference signal obtained by sampling with a moment when a sampling timing signal reaches the downstream detection point or with a transmitting moment when it is transmitted at the detection point;

D. calculating a cross-correlation function of the digital sample sequence as described in step B and the digital sample sequence as described in step C;

E. determining presence of an impairment source in a signal delivering path passing through the downstream detection point based on a condition that a cross-correlation peak caused by the impairment source exists in a cross-correlation function graph obtained by calculating the cross-correlation function.

8. The method according to claim 7, **characterized in that** a step after the step B is further included:

B1. selecting an upstream detection point upstream of the cable network, picking up an interference signal in the upstream detection point, sampling the interference signal, and associating a digital sample sequence of the interference signal obtained by sampling with a moment when the sampling timing signal reaches the upstream detection point or with a transmitting moment when it is transmitted at the upstream detection point; and

a step after the step D is further included:

D1. calculating a cross-correlation function of the digital sample sequence as described in step B and the digital sample sequence as described in step B1; and

steps after the step E are further included:

F. selecting the cross-correlation peak only caused by the impairment source in the signal delivering path as described in step E in the cross-correlation function graph obtained by calculating the cross-correlation function as described in step D1;

G. determining the location of the impairment source in the line based on a time delay value of the cross-correlation peak caused by the impairment source as described in step F.

9. A method for locating impairment sources in cable network, **characterized in that** comprising:

A. transmitting a sampling timing signal to a cable network line;

B. selecting an upstream detection point upstream of the cable network, picking up an interference signal in the upstream detection point, sampling the interference signal, and associating a digital sample sequence of the interference signal obtained by sampling with a moment when a sampling timing signal reaches the upstream detection point or with a transmitting moment when it is transmitted at the upstream detection point;

C. selecting a downstream detection point downstream of the cable network, picking up an interference signal in the downstream detection point, sampling the interference signal, and associating a digital sample sequence of the interference signal obtained with a moment when a sampling timing signal reaches the downstream detection point or with a transmitting moment when it is transmitted at the downstream detection point;

D. calculating a cross-correlation function of the digital sample sequence as described in step B and the digital sample sequence as described in step C;

E. determining presence of an impairment source in a signal delivering path passing through the downstream detection point based on a condition that a cross-correlation peak caused by the impairment source exists in a cross-correlation function graph obtained by calculating the cross-correlation function.

10. The method according to claim 9, **characterized in that** a step after the step C is further included:

C1. selecting a second downstream detection point downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when the sampling timing signal reaches the second downstream detection point;

Step D further includes steps of:

D1: adjusting the digital sample sequence as described in step C and the digital sample sequence as described in step C1 so that the two sample sequences have the same amplitude value;
D2. calculating respectively cross-correlation functions of each of the digital sample sequences having the same amplitude value and the digital sample sequence as described in step B;

Step E further includes a step of:

determining presence of impairment sources each in signal delivering paths passing through the downstream detection points as described respectively in step C and step C1, based on a condition that cross-correlation peaks caused by the impairment sources in each case exist in two cross-correlation function graphs obtained by calculating the cross-correlation functions as described in step D2; and

steps after the step E are further included:

F. from the two cross-correlation function graphs, selecting a cross-correlation peak only caused by the impairment source in the signal delivering path passing through the downstream point as described in step C and a cross-correlation peak only caused by the impairment source in a signal delivering path passing through the downstream point as described in step C1 respectively;
G. ranking degrees of damages to the network service resulted from impairment sources in the two different signal delivering paths, based on an order of amplitude value of the cross-correlation peaks selected from the two cross-correlation function graphs as described in step F.

11. The method according to claim 9, **characterized in that** a step after the step A is further included:

A1. delivering a second sampling timing signal in a cable network line;

a step after the step B is further included:

B1. picking up an interference signal in the upstream detection point for the second time, sampling the interference signal, and associating a digital sample sequence of the interference signal obtained by sampling with a moment when a second sampling timing signal reaches the upstream detection point or with a transmitting moment when it is transmitted at the upstream detection point;

a step after the step C is further included:

C1. selecting a second downstream detection point downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when a second sampling timing signal reaches the second downstream detection point, or with a transmitting moment when it is transmitted at the second downstream detection point;

Step D further includes steps of:

D1: adjusting the digital sample sequence as described in step C or the digital sample sequence as described in step C1 so that the two adjusted sample sequences have the same amplitude value.
D2. in the two digital sample sequences which have the same amplitude value, calculating a cross-correlation function of the digital sample sequence as described in step C and the digital sample sequence as described in step B, and calculating a cross-correlation function of the digital sample sequence as described in step C1 and the digital sample sequence as described in step B1;

step E further includes a step of:

determining presence of impairment sources each in signal delivering paths passing through the downstream detection points as described respectively in step C and step C1, based on a condition that cross-correlation peaks caused by the impairment sources in each case exist in two cross-correlation function graphs obtained by calculating the cross-correlation functions as described in step D2;

steps after the step E are further included:

F. from the two cross-correlation function graphs, selecting a cross-correlation peak only caused by the impairment source in the signal delivering path passing through the downstream point as described in step C and a cross-correlation peak only caused by the impairment source in a signal delivering path passing through the downstream point as described in step C1 respectively;
G. ranking degrees of damages to the network service resulted from impairment sources in the two different signal delivering paths, based on an order of amplitude value of the cross-correlation peaks selected from the two cross-correlation function graphs as described in step F.

12. The method according to claim 9, **characterized in that** a step after the step E is further included:

F. selecting the cross-correlation peak only caused by the impairment source in the signal delivering path as described in step E in the cross-correlation function graph;
G. determining the location of the impairment source, based on a time delay value of the cross-correlation peak only caused by the impairment source in the signal delivering path as described in step E.

13. The method according to claim 12, **characterized in that**, when the interference signal as described in step C is a reflection signal, step G further includes a step of:

determining the presence of the impairment source downstream of the downstream detection point, based on conditions that absolute values of differences between time delay values of the two cross-correlation peaks only caused by the impairment source in the signal delivering path as described in step E and the time delay value of the cross-correlation peak caused by the downstream detection point are the same, and the signs of these two time delay value are opposite.

14. The method according to claim 12, **characterized in that**, when the interference signal as described in step C is an external interference signal or a common path distortion signal, step G further includes a step of:

determining the presence of the impairment source downstream of the downstream detection point, based on a condition that the position, to which the time delay value of a cross-correlation peak only caused by the impairment source in the signal delivering path as described in step E corresponds, is the downstream detection point.

15. The method according to claim 12, **characterized in that**, when the interference signal as described in step C is an external interference signal or a common path distortion signal, step C further include a step of:

C1. selecting a second downstream detection point in the downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when the sampling timing signal reaches the second downstream detection point;

a step after the step D is further included:

D1. calculating a cross-correlation function of the digital sample sequence as described in step B and the digital sample sequence as described in step C1;

a step after the step E is further included:

E1. determining presence of an impairment source in a signal delivering path passing through the second downstream detection point based on a condition that a cross-correlation peak caused by the impairment source exists in a cross-correlation function graph obtained by calculating the cross-correlation function as described in step D1; and

Step F further includes a step of:

based on a condition that a spacing between the pair of the cross-correlation peaks in one graph is the same to a spacing between the pair of the cross-correlation peaks in the other graph, determining presence of a cross-correlation peak only caused by the impairment source in the signal delivering path as described in step E and presence of a parasitic cross-correlation peak in the cross-correlation function graph as described in step E; determining presence of a cross-correlation peak only caused by the impairment source in the signal delivering path as described in step E1 and presence of a parasitic cross-correlation peak in the cross-correlation function graph as described in step E1; and determining that the position relationship between the pair of the cross-correlation peaks in one graph is opposite to the position relationship between the pair of the cross-correlation peaks in the other graph.

16. The method according to claim 12, **characterized in that**, when the interference signal as described in step C is an external interference signal or a common path distortion signal, step A further include a step of:

A1. delivering a second sampling timing signal in a cable network line;

a step after the step B is further included:

B1. picking up an interference signal in the upstream detection point for the second time, sampling the interference signal, and associating a digital sample sequence of the interference signal obtained by sampling with a moment when a second sampling timing signal reaches the upstream detection point or with a transmitting moment when it is transmitted at the upstream detection point;

a step after the step C is further included:

C1. selecting a second downstream detection point in the downstream of the cable network so that the second downstream detection point and the downstream detection point as described in step C do not belong to the same cable branch; picking up an interference signal in the second downstream detection point, sampling the interference signal, and associating a digital sample sequence of the interference signal obtained by sampling with a moment when a second sampling timing signal reaches the second downstream detection point, or with a transmitting moment when it is transmitted at the second downstream detection point;

a step after the step D is further included::

D1. calculating a cross-correlation function of the digital sample sequence as described in step Bland the digital sample sequence as described in step C1;

a step after the step E is further included:

E1. determining presence of an impairment source in a signal delivering path passing through the second downstream detection point based on a condition that a cross-correlation peak caused by the impairment source exists in a cross-correlation function graph obtained by calculating the cross-correlation function as described in step D1; and

Step F further includes a step of:

based on a condition that a spacing between the pair of the cross-correlation peaks in one graph is the same to a spacing between the pair of the cross-correlation peaks in the other graph, determining presence of a cross-correlation peak only caused by the impairment source in the signal delivering path as described in step E and presence of a parasitic cross-correlation peak in the cross-correlation function graph as described in step E; determining presence of a cross-correlation peak only caused by the impairment source in the signal delivering path as described in step E1 and presence of a parasitic cross-correlation peak in the cross-correlation function graph as described in step E1; and determining that the position relationship between the pair of the cross-correlation peaks in one graph is opposite to the position relationship between the pair of the cross-correlation peaks in the other graph.

17. The method according to claim 15 or 16, **characterized in that** a step after the step F is further included:

in the cross-correlation peaks which have the same spacing in the two graphs, calculating a ratio of amplitude of two cross-correlation peaks in each of graphs, respectively; based on the two ratios of amplitude, determining that one of cross-correlation peaks in each graph is the cross-correlation peak only caused by the impairment source in the signal delivering path as described in step E, or is the cross-correlation peak only caused by the impairment source in the signal delivering path as described in step E1.

18. The method according to claim 15, **characterized in that** the step D further includes steps of:

D21: adjusting the digital sample sequence as described in step C or the digital sample sequence as described in step C1 so that the two adjusted sample sequences have the same amplitude value;
D22. calculating respectively cross-correlation functions of each of the digital sample sequences which have the same amplitude value and the digital sample sequence as described in step B;

a step after the step F is further included:

in the two pairs of cross-correlation peaks which have the same spacing in the graph as described in step E and in the graph as described in step E1, determining that a cross-correlation peak with the largest amplitude is the cross-correlation peak only caused by the impairment source in the signal delivering path as described in step E, or is the cross-correlation peak only caused by the impairment source in the signal delivering path as described in step E1.

19. The method according to claim 16, **characterized in that** the step D further includes steps of:

D31: adjusting the digital sample sequence as described in step C or the digital sample sequence as described in step C1 so that the two adjusted sample sequences have the same amplitude value;
D32. in the two digital sample sequences which have the same amplitude value, calculating a cross-correlation function of the digital sample sequence as described in step C and the digital sample sequence as described in step B, and calculating a cross-correlation function of the digital sample sequence as described in step C1 and the digital sample sequence as described in step B1;

a step after the step F is further included:

in the two pairs of cross-correlation peaks which have the same spacing in the graph as described in step E and in the graph as described in step E1, determining that a cross-correlation peak with the largest amplitude is the cross-correlation peak only caused by the impairment source in the signal delivering path as described in step E, or is the cross-correlation peak only caused by the impairment source in the signal delivering path as described in step E1.

FIG. 1

FIG. 2 (A)　　FIG. 2 (B)　　FIG. 2 (C)　　FIG. 2 (D)　　FIG. 2 (E)

FIG. 3 （A）

FIG. 3 （B）

FIG. 3 （C）

FIG. 3 （D）

FIG. 3 （E）

FIG. 3 （F）

FIG. 3 （G）

FIG. 4-1 （A）

FIG. 4-1 （B）

FIG. 4-1 （C）

FIG. 4-2 （A）

$2T_{47}$　　$2T_{279}$

FIG. 4-2 （B）

$2T_{234} - 2T_{279}$　　　　　$2T_{234}$　　　　　$2T_{234} + 2T_{279}$

$2T_{234} - 2T_{47}$　　　　　$2T_{234} + 2T_{279} - 2T_{47}$

FIG. 4-2 （C）

$2T_{234}$　　　$2T_{234} + 2T_{279}$

FIG. 4-3 （A）

G'

G'  G'

0

t'

$2T_{217}$

$2T_{218}$

FIG. 4-3 （B）

0

$2T_{234}$    $2T_{234} + 2T_{278}$    t''

$2T_{234} - 2T_{248}$    $2T_{234} + 2T_{278} - 2T_{247}$

$2T_{234} - 2T_{247}$    $2T_{234} + 2T_{278} - 2T_{248}$

FIG. 4-3 （C）

0

0

FIG. 5 （A）

FIG. 5 （B）

FIG. 5 （C）

FIG. 5 （D）

FIG. 5 （E）

FIG. 5 （F）

FIG. 5 （G）

FIG. 5 （H）

FIG. 6

$2\mathrm{T}_{113} - (\mathrm{T}_{113} - \mathrm{T}_{123})$      $2\mathrm{T}_{113}$

$2\mathrm{T}_{123}$     $2\mathrm{T}_{123} + (\mathrm{T}_{113} - \mathrm{T}_{123})$

FIG. 7（A）

$2T_{I23}$  $2T_{I13}$  t

$2T_{I23}$  $2T_{I13}$  t

FIG. 7（B）

$2T_{I13}-(T_{I13}-T_{I23})$  $2T_{I13}$  t

$2T_{I23}$  $2T_{I23}+(T_{I13}-T_{I23})$  t

FIG. 7（C）

radio
frequency
port of
cable
modem

tuner
811

demodulator
812

medium
access
controller
814

microprocessor
815

memory
816

subscriber
interface
controller
817

modulator
813

tunable
bandpass filter
818

A/D converter
819

FIG. 8

radio
frequency
port

sampling
timing
signal
transmitter
922

microprocessor
915

memory
916

tunable bandpass
filter
918

A/D converter
919

cable modem
921

FIG. 9 （A）

916

memory

923

sampling timing signal receiver

915

microprocessor

918

tunable bandpass filter

919

A/D converter

921

cable modem

radio frequency port

FIG. 9 （B）

816

memory

811

tuner

812

demodulator

814

medium access controller

815

microprocessor

817

subscriber interface controller

813

modulator

radio frequency port

1032

bandpass filter

1031

common path distortion reference signal generator

819

A/D converter

FIG. 10 （A）

FIG. 10 （B）

FIG. 11 （A）

FIG. 11 （B）

| **INTERNATIONAL SEARCH REPORT** | International application No. |
|---|---|
| | **PCT/CN2016/072496** |

**A. CLASSIFICATION OF SUBJECT MATTER**

H04N 17/00 (2006.01) i

According to International Patent Classification (IPC) or to both national classification and IPC

**B. FIELDS SEARCHED**

Minimum documentation searched (classification system followed by classification symbols)

H04N

Documentation searched other than minimum documentation to the extent that such documents are included in the fields searched

Electronic data base consulted during the international search (name of data base and, where practicable, search terms used)

CNPAT, CNKI, WPI, EPODOC, IEEE: cable, time, radio frequency, common channel distortion, fault, cable television, line, tim+ signal, reference, sampl+, associat+, radio, interference, CDP, impaired, correlation, peak, locat+

**C. DOCUMENTS CONSIDERED TO BE RELEVANT**

| Category* | Citation of document, with indication, where appropriate, of the relevant passages | Relevant to claim No. |
|---|---|---|
| PX | CN 104754325 A (LIU, Jianqiu), 01 July 2015 (01.07.2015), claims 1-19 | 1-19 |
| X | US 2011043640 A1 (ARCOM DIGITAL, LLC.), 24 February 2011 (24.02.2011), claim 1, description, paragraphs [0044]-[0051], and figures 1 and 7 | 1-2 |
| Y | US 2011043640 A1 (ARCOM DIGITAL, LLC.), 24 February 2011 (24.02.2011), claim 1, description, paragraphs [0044]-[0051], and figures 1 and 7 | 3-4, 7-8 |
| Y | US 2006248564 A1 (ZINEVITCH, V.M.), 02 November 2006 (02.11.2006), claims 9-14, and description, paragraphs [0054]-[0062] and [0086]-[0095] | 3-4, 7-8 |
| A | US 2011043640 A1 (ARCOM DIGITAL, LLC), 24 February 2011 (24.02.2011), claim 1, description, paragraphs [0044]-[0051], and figures 1 and 7 | 5-6, 9-19 |
| A | CN 101526566 A (THE STATE RADIO_MONITORING_CENTER), 09 September 2009 (09.09.2009), the whole document | 1-19 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 05 April 2016 (05.04.2016) | **28 April 2016 (28.04.2016)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **ZHANG, Qian** Telephone No.: (86-10) **82245296** |

Form PCT/ISA/210 (second sheet) (July 2009)

# EP 3 261 343 A1

## INTERNATIONAL SEARCH REPORT
### Information on patent family members

| Patent Documents referred in the Report | Publication Date | Patent Family | Publication Date |
|---|---|---|---|
| CN 104754325 A | 01 July 2015 | None | |
| US 2011043640 A1 | 24 February 2011 | US 2015077129 A1 | 19 March 2015 |
| | | EP 2468007 A1 | 27 June 2012 |
| | | JP 2014140174 A | 31 July 2014 |
| | | JP 2013502827 A | 24 January 2013 |
| | | US 2013147969 A1 | 13 June 2013 |
| | | WO 2011022197 A1 | 24 February 2011 |
| | | US 2014165126 A1 | 12 June 2014 |
| US 2006248564 A1 | 02 November 2006 | JP 2008532388 A | 14 August 2008 |
| | | EP 1854304 A2 | 14 November 2007 |
| | | WO 2006091708 A2 | 31 August 2006 |
| CN 101526566 A | 09 September 2009 | None | |

Form PCT/ISA/210 (patent family annex) (July 2009)

**REFERENCES CITED IN THE DESCRIPTION**

**Patent documents cited in the description**

- US 20080320541 A
- US 2110043640 A
- US 20060248564 A
- US 20080140823 A
- US 6772437 B1